# EUROPÄISCHE PATENTSCHRIFT

(11) **EP 2 371 016 B1**
(45) Veröffentlichungstag und Bekanntmachung des Hinweises auf die Patenterteilung: **07.08.2019**
(21) Anmeldenummer: 09759687.8
(22) Anmeldetag: 26.11.2009
(51) Int. Cl.: H01L 51/54, H01L 51/52

(54) **ORGANISCHE ELEKTROLUMINESZENZVORRICHTUNG MIT TRIAZINDERIVATEN**
ORGANIC LIGHT EMITTING EVICES COMPRISING TRIAZINE DERIVATIVES
DISPOSITIF ÉLECTROLUMINESCENT ORGANIQUE CONTENANT DES DÉRIVÉS TRIAZINE

(30) Priorität: 22.12.2008 DE 102008064200
(43) Veröffentlichungstag der Anmeldung: 05.10.2011
(60) Teilanmeldung: 14004087.4
(73) Patentinhaber: Merck Patent GmbH, 64293 Darmstadt (DE)
(72) Erfinder: PFLUMM, Christof, 60318 Frankfurt am Main (DE); LEU, Simone, 67596 Dittelsheim-Hessloch (DE); KAISER, Joachim, 64293 Darmstadt (DE); PARHAM, Amir, Hossain, 65929 Frankfurt am Main (DE); VOGES, Frank, 67098 Bad Duerkheim (DE); KROEBER, Jonas, Valentin, 60311 Frankfurt am Main (DE); BUESING, Arne, 65929 Frankfurt am Main (DE)
(86) Internationale Anmeldenummer: PCT/EP2009/008441
(87) Internationale Veröffentlichungsnummer: WO 2010/072300

(56) Entgegenhaltungen:
- WO-A1-2005/053055
- WO-A1-2010/015306

## Beschreibung

Die vorliegende Erfindung betrifft organische Elektrolumineszenzvorrichtungen, welche Triazinderivate als Elektronentransportmaterialien enthalten.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Allerdings sind noch weitere Verbesserungen wünschenswert. So gibt es insbesondere in Bezug auf die Lebensdauer, die Effizienz und die Betriebsspannung organischer Elektrolumineszenzvorrichtungen noch Verbesserungsbedarf. Weiterhin ist es erforderlich, dass die Verbindungen eine hohe thermische Stabilität und eine hohe Glasübergangstemperatur aufweisen und sich unzersetzt sublimieren lassen.

Insbesondere bei den Elektronentransportmaterialien sind noch Verbesserungen der Eigenschaften wünschenswert, da gerade auch die Eigenschaften des Elektronentransportmaterials einen wesentlichen Einfluss auf die oben genannten Eigenschaften der organischen Elektrolumineszenzvorrichtung ausüben. Insbesondere besteht Verbesserungsbedarf bei Elektronentransportmaterialien, welche gleichzeitig zu guter Effizienz, hoher Lebensdauer und geringer Betriebsspannung führen. Gerade auch die Eigenschaften des Elektronentransportmaterials sind häufig limitierend für die Lebensdauer, die Effizienz und die Betriebsspannung der organischen Elektrolumineszenzvorrichtung.

Dabei wäre es wünschenswert, Elektronentransportmaterialien zur Verfügung zu haben, welche zu einer besseren Elektroneninjektion in die emittierende Schicht führen, da eine elektronenreichere Emissionsschicht zu einer besseren Effizienz führt. Außerdem kann durch eine bessere Injektion die Betriebsspannung gesenkt werden. Hierfür sind daher weitere Verbesserungen des Elektronentransportmaterials erforderlich.

Weiterhin besteht generell noch Verbesserungsbedarf bei der Prozessierbarkeit der Materialien, da viele Materialien, die gemäß dem Stand der Technik in organischen Elektrolumineszenzvorrichtungen verwendet werden, dazu neigen, an der Aufdampfquelle im Herstellungsprozess der Elektrolumineszenzvorrichtung zu kristallisieren und somit die Aufdampfquelle zu verstopfen. Diese Materialien können daher nur unter erhöhtem technischen Aufwand in der Massenproduktion eingesetzt werden.

Elektrolumineszenzvorrichtungen, die AlQ₃ als Elektronenleiter verwenden, sind schon lange bekannt und wurden schon 1993 in US 4,539,507 beschrieben. AlQ₃ wird seither häufig als Elektronentransportmaterial verwendet, hat allerdings mehrere Nachteile: Es lässt sich nicht rückstandsfrei aufdampfen, da es sich bei der Sublimationstemperatur teilweise zersetzt, was insbesondere für Produktionsanlagen ein großes Problem darstellt. Dies hat zur Folge, dass die Aufdampfquellen immer wieder gereinigt oder gewechselt werden müssen. Des Weiteren gelangen Zersetzungsprodukte von AlQ₃ in die OLED, die dort zu einer verringerten Lebensdauer und reduzierten Quanten- und Leistungseffizienz beitragen. AlQ₃ hat außerdem eine niedrige Elektronenbeweglichkeit, was zu höheren Spannungen und damit zu einer niedrigeren Leistungseffizienz führt. Um Kurzschlüsse im Display zu vermeiden, würde man gern die Schichtdicke erhöhen; dies ist mit AlQ₃ wegen der geringen Ladungsträgerbeweglichkeit und der daraus resultierenden Spannungserhöhung nicht möglich. Die Ladungsträgerbeweglichkeit anderer Elektronenleiter (US 4,539,507) ist ebenfalls zu gering, um dickere Schichten damit aufzubauen, wobei die Lebensdauer der OLED noch schlechter ist als bei Verwendung von AlQ₃. Als ungünstig erweist sich auch die Eigenfarbe (im Feststoff gelb) von AlQ₃, die gerade bei blauen OLEDs durch Reabsorption und schwache Reemission zu Farbverschiebungen führen kann. Hier sind blaue OLEDs nur mit starken Effizienz- bzw. Farborteinbußen darstellbar.

Es besteht also weiterhin Bedarf an Elektronentransportmaterialien, die in organischen Elektrolumineszenzvorrichtungen zu guten Effizienzen und gleichzeitig zu hohen Lebensdauern führen. Es wurde nun überraschend gefunden, dass organische Elektrolumineszenzvorrichtungen, die bestimmte - im Folgenden aufgeführte - Triazinderivate als Elektronentransportmaterialien enthalten, deutliche Verbesserungen gegenüber dem Stand der Technik aufweisen. Mit diesen Materialien ist es möglich, gleichzeitig hohe Effizienzen und lange Lebensdauern zu erhalten, was mit Materialien gemäß dem Stand der Technik nicht möglich ist. Zudem wurde gefunden, daß zusätzlich die Betriebsspannungen deutlich gesenkt werden können, was zu höheren Leistungseffizienzen führt.

Weiterhin wurde gefunden, dass organische elektronische Vorrichtungen, die Triazinderivate als Elektronentransportmaterialien in Kombination mit einer organischen Alkalimetallverbindung enthalten, deutliche Verbesserungen gegenüber dem Stand der Technik aufweisen. Mit dieser Materialkombination werden gleichzeitig hohe Effizienzen und lange Lebensdauern erzielt und die Betriebsspannungen gesenkt.

In der US 6,229,012 und US 6,225,467 ist die Verwendung von Fluoren- bzw. Biphenylderivaten, welche mit Triazingruppen substituiert sind, als Elektronentransportmaterial in OLEDs offenbart. Es ist den Patenten jedoch nicht zu entnehmen, dass gerade Materialien, welche statt der Fluorengruppe eine Spirobifluorengruppe aufweisen, wesentliche Vorteile gegenüber den in den oben genannten Patenten offenbarten Materialien bieten.

WO 2010/015306 A1 offenbart phosphoreszierende organische elektrolumineszierende Vorrichtungen, die in der Emissionsschicht als Matrixmaterial mit Triazin substituierte Spirobifluorenderivate enthalten.

In der WO 2005/053055 wird die Verwendung von Triazinderivaten, insbesondere von Spirobifluorenderivaten, welche mit Triazingruppen substituiert sind, als Lochblockiermaterial in einer Lochblockierschicht in phosphoreszierenden OLEDs offenbart. Es ist der Anmeldung jedoch nicht zu entnehmen, dass sich diese Materialien auch als Elektronentransportmaterialien für fluoreszierende Elektrolumineszenzvorrichtungen eignen.

Gegenstand der Erfindung ist somit eine organische Elektrolumineszenzvorrichtung enthaltend Anode, Kathode und mindestens eine emittierende Schicht, welche mindestens einen fluoreszierenden Emitter enthält, oder mindestens eine emittierende Schicht, welche mindestens einen phosphoreszierenden Emitter enthält und welche in Kombination mit einer folgenden Lochblockierschicht eingesetzt wird, dadurch gekennzeichnet, dass zwischen der emittierenden Schicht bzw. der Lochblockierschicht und der Kathode eine Elektronentransportschicht eingebracht ist, welche mindestens eine Verbindung gemäß Formel (1) oder Formel (2) enthält, 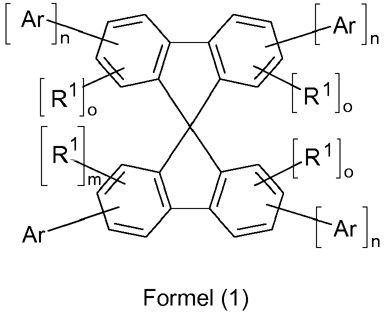 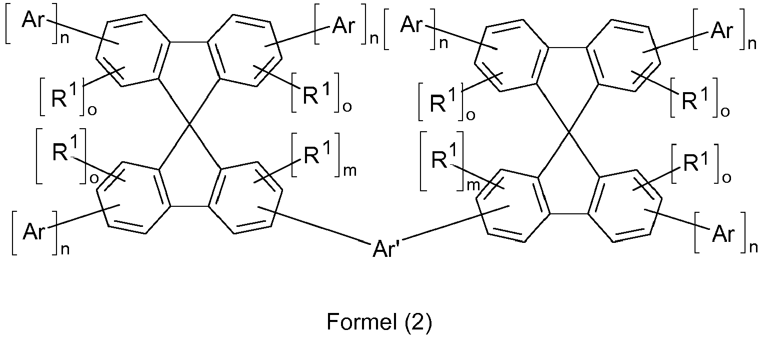 wobei für die verwendeten Symbole und Indizes gilt:
- Ar: ist eine Gruppe der folgenden Formel (3), 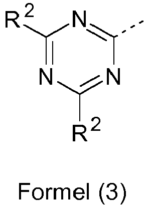 wobei die gestrichelte Bindung die Bindung an das Spirobifluoren andeutet;
- Ar': ist eine Gruppe der folgenden Formel (4), 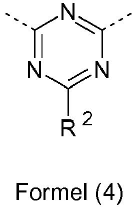 wobei die gestrichelten Bindungen die Bindungen an das Spirobifluoren andeutet;
- R¹, R²: ist bei jedem Auftreten gleich oder verschieden H, D, F, Cl, Br, I, CHO, N(R³)₂, N(Ar¹)₂, B(Ar¹)₂, C(=O)Ar¹, P(=O)(Ar¹)₂, S(=O)Ar¹, S(=O)₂Ar¹, CR³=CR³Ar¹, CN, NO₂, Si(R³)₃, B(OR³)₂, B(R³)₂, B(N(R³)2)2, OSO₂R³, eine geradkettige Alkyl-, Alkenyl-, Alkinyl-, Alkoxy- oder Thioalkoxygruppe mit 1 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C , Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Kombination dieser Systeme; dabei können zwei oder mehrere benachbarte Substituenten R¹ auch miteinander ein mono- oder poly-cyclisches, aliphatisches oder aromatisches Ringsystem bilden;
- Ar¹: ist bei jedem Auftreten gleich oder verschieden ein aromatisches oder heteroaromatisches Ringsystem mit 5 bis 30 aromatischen Ringatomen, das mit einem oder mehreren Resten R³ substituiert sein kann; dabei können auch zwei Reste Ar¹, welche an dasselbe Stickstoff-, Phosphor- oder Boratom binden, durch eine Einfachbindung oder eine Brücke, ausgewählt aus B(R³), C(R³)₂, Si(R³)₂, C=O, C=NR³, C=C(R³)₂, O, S, S=O, SO₂,N(R³), P(R³) und P(=O)R³, miteinander verknüpft sein;
- R³: ist bei jedem Auftreten gleich oder verschieden H, D oder ein aliphatischer, aromatischer und/oder heteroaromatischer Kohlenwasserstoffrest mit 1 bis 20 C-Atomen, in dem auch H-Atome durch D oder F ersetzt sein können; dabei können zwei oder mehrere benachbarte Substituenten R³ auch miteinander ein mono- oder polycyclisches, aliphatisches oder aromatisches Ringsystem bilden;
- n: ist 0 oder 1;
- m: ist 0, 1, 2 oder 3;
- o: ist 0, 1, 2, 3 oder 4, wenn im selben Ring n = 0 ist und ist 0, 1, 2 oder 3, wenn im selben Ring n = 1 ist.

Unter einer organischen Elektrolumineszenzvorrichtung wird eine Vorrichtung verstanden, welche Anode, Kathode und mindestens eine emittierende Schicht, welche zwischen der Anode und der Kathode angeordnet ist, enthält, wobei mindestens eine Schicht zwischen der Anode und der Kathode mindestens eine organische bzw. metallorganische Verbindung enthält. Dabei enthält die Elektronentransportschicht mindestens eine Verbindung der oben aufgeführten Formel (1) oder (2). Eine organische Elektrolumineszenzvorrichtung muss nicht notwendigerweise nur Schichten enthalten, welche aus organischen oder metallorganischen Materialien aufgebaut sind. So ist es auch möglich, dass eine oder mehrere Schichten anorganische Materialien enthalten oder ganz aus anorganischen Materialien aufgebaut sind.

Eine fluoreszierende Verbindung im Sinne dieser Erfindung ist eine Verbindung, welche bei Raumtemperatur Lumineszenz aus einem angeregten Singulett-Zustand zeigt. Im Sinne dieser Erfindung sollen insbesondere alle lumineszierenden Verbindungen, welche keine Schweratome enthalten, also keine Atome mit der Ordnungszahl größer 36, als fluoreszierende Verbindungen angesehen werden.

Eine phosphoreszierende Verbindung im Sinne dieser Erfindung ist eine Verbindung, welche bei Raumtemperatur Lumineszenz aus einem angeregten Zustand mit höherer Spinmultiplizität zeigt, also einer Spinmultiplizität > 1, insbesondere aus einem angeregten Triplettzustand. Im Sinne dieser Erfindung sollen insbesondere alle lumineszierenden Iridium- und Platinverbindungen als phosphoreszierende Verbindungen angesehen werden.

Eine Arylgruppe im Sinne dieser Erfindung enthält mindestens 6 C-Atome; eine Heteroarylgruppe im Sinne dieser Erfindung enthält mindestens 2 C-Atome und mindestens 1 Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe verstanden.

Unter einer kondensierten Aryl- oder Heteroarylgruppe im Sinne dieser Erfindung wird eine Aryl- bzw. Heteroarylgruppe verstanden, in der mindestens zwei aromatische oder heteroaromatische Ringe, beispielsweise Benzolringe, miteinander "verschmolzen", d. h. durch Anellierung einander ankondensiert sind, also mindestens eine gemeinsame Kante und dadurch auch ein gemeinsames aromatisches System aufweisen. So sind beispielsweise Systeme wie Naphthalin, Anthracen, Phenanthren, Benzanthracen, Pyren, etc. als kondensierte Arylgruppen und Chinolin, Acridin, Benzothiophen, Carbazol, etc. als kondensierte Heteroarylgruppen im Sinne dieser Erfindung zu sehen, während beispielsweise Fluoren, Spirobifluoren, etc. keine kondensierten Arylgruppen darstellen, da es sich hierbei um separate aromatische Elektronensysteme handelt.

Ein aromatisches Ringsystem im Sinne dieser Erfindung enthält mindestens 6 C-Atome im Ringsystem. Ein heteroaromatisches Ringsystem im Sinne dieser Erfindung enthält mindestens 2 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine kurze, nicht-aromatische Einheit (bevorzugt weniger als 10 % der von H verschiedenen Atome), wie z. B. ein sp³-hybridisiertes C-, N- oder O-Atom, unterbrochen sein können. So sollen beispielsweise auch Systeme wie 9,9'-Spirobifluoren, 9,9-Diarylfluoren, Triarylamin, Diarylether, Stilben, Benzophenon, etc. als aromatische Ringsysteme im Sinne dieser Erfindung verstanden werden. Ebenso werden unter einem aromatischen bzw. heteroaromatischen Ringsystem Systeme verstanden, in denen mehrere Aryl- bzw. Heteroarylgruppen durch Einfachbindungen miteinander verknüpft sind, beispielsweise Biphenyl, Terphenyl oder Bipyridin.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, tert-Pentyl, 2-Pentyl, Cyclopentyl, n-Hexyl, s-Hexyl, tert-Hexyl, 2-Hexyl, 3-Hexyl, Cyclohexyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Trifluormethyl, Pentafluorethyl und 2,2,2-Trifluorethyl verstanden. Unter einer Alkenylgruppe werden besonders bevorzugt die Reste Ethenyl, Propenyl, Butenyl, Pentenyl, Cyclopentenyl, Hexenyl, Cyclohexenyl, Heptenyl, Cycloheptenyl, Octenyl und Cyclooctenyl verstanden. Unter einer Alkinylgruppe werden besonders bevorzugt die Reste Ethinyl, Propinyl, Butinyl, Pentinyl, Hexinyl, Heptinyl oder Octinyl verstanden. Unter einer C₁- bis C₄₀-Alkoxygruppe werden besonders bevorzugt Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Benzanthracen, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Benzofluoren, Dibenzofluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt weisen die Verbindungen gemäß Formel (1) und (2) eine Glasübergangstemperatur T_{G} von größer als 70 °C auf, besonders bevorzugt größer als 90 °C, ganz besonders bevorzugt größer als 110 °C.

In nochmals einer bevorzugten Ausführungsform der Erfindung steht der Rest R², welcher an die Gruppen der Formeln (3) bzw. (4) gebunden ist, gleich oder verschieden bei jedem Auftreten für H, D, eine geradkettige Alkyl- oder Alkoxygruppe mit 1 bis 10 C-Atomen oder eine verzweigte oder cyclische Alkyl- oder Alkoxygruppe mit 3 bis 10 C-Atomen, die jeweils mit einem oder mehreren Resten R³ substituiert sein kann, wobei ein oder mehrere H-Atome durch D oder F ersetzt sein können, oder ein aromatisches oder heteroaromatisches Ringsystem mit 5 bis 30 aromatischen Ringatomen, das jeweils durch einen oder mehrere Reste R³ substituiert sein kann, oder eine Kombination dieser Systeme. In einer besonders bevorzugten Ausführungsform der Erfindung steht der Rest R² gleich oder verschieden bei jedem Auftreten für ein aromatisches oder heteroaromatisches Ringsystem mit 5 bis 25 aromatischen Ringatomen, das jeweils durch einen oder mehrere Reste R³ substituiert sein kann. Ganz besonders bevorzugt steht der Rest R² gleich oder verschieden bei jedem Auftreten für ein aromatisches oder heteroaromatisches Ringsystem mit 5 bis 14 aromatischen Ringatomen, das jeweils durch einen oder mehrere Reste R³ substituiert sein kann, insbesondere für Phenyl, Naphthyl oder ortho-, meta- bzw. para-Biphenyl, welches jeweils durch einen oder mehrere Reste R³ substituiert sein kann, jedoch bevorzugt unsubstituiert ist.

In nochmals einer bevorzugten Ausführungsform der Erfindung steht der Rest R¹, welcher direkt an das Spirobifluoren gebunden ist, gleich oder verschieden bei jedem Auftreten für H, D, eine geradkettige Alkyl- oder Alkoxygruppe mit 1 bis 10 C-Atomen oder eine verzweigte oder cyclische Alkyl- oder Alkoxygruppe mit 3 bis 10 C-Atomen, die jeweils mit einem oder mehreren Resten R² substituiert sein kann, wobei ein oder mehrere H-Atome durch D oder F ersetzt sein können, oder ein aromatisches oder heteroaromatisches Ringsystem mit 5 bis 30 aromatischen Ringatomen, das jeweils durch einen oder mehrere Reste R³ substituiert sein kann, oder eine Kombination dieser Systeme. In einer besonders bevorzugten Ausführungsform der Erfindung steht der Rest R¹ gleich oder verschieden bei jedem Auftreten für H, D, eine geradkettige Alkylgruppe mit 1 bis 5 C-Atomen oder eine verzweigte oder cyclische Alkylgruppe mit 3 bis 6 C-Atomen, die jeweils mit einem oder mehreren Resten R³ substituiert sein kann, wobei ein oder mehrere H-Atome durch D oder F ersetzt sein können, oder für ein aromatisches oder heteroaromatisches Ringsystem mit 5 bis 25 aromatischen Ringatomen, das jeweils durch einen oder mehrere Reste R³ substituiert sein kann.

In einer weiteren bevorzugten Ausführungsform der Erfindung ist die Gruppe Ar in 2-Position des Spirobifluorens gebunden. Falls mehr als eine Gruppe Ar vorhanden ist, sind die anderen Gruppen Ar bevorzugt in 7-Position und/oder in der 2'-Position und/oder in der 7'-Position gebunden. Besonders bevorzugte Verbindungen gemäß Formel (1) und (2) sind daher die Verbindungen gemäß den Formeln (5) und (6), 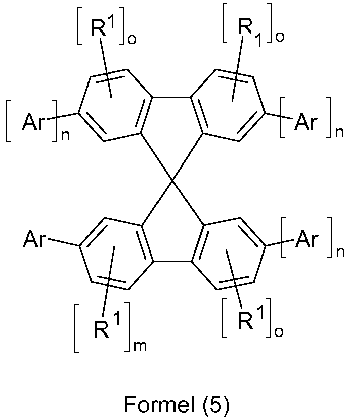 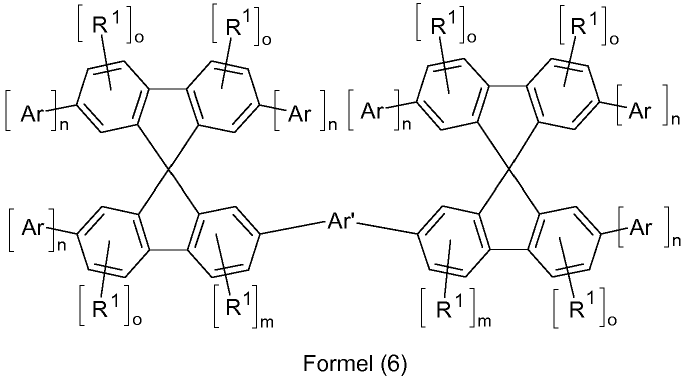 wobei die Symbole und Indizes dieselbe Bedeutung haben, wie oben beschrieben und wobei für n = 0 in der entsprechenden Position auch ein Substituent R¹ gebunden sein kann.

In einer bevorzugten Ausführungsform von Verbindungen gemäß Formel (1), (2), (5) und (6) ist der Index m = 0, d. h. außer der Gruppe Ar ist an diesem Benzolring kein weiterer Substituent gebunden.

In einer weiteren bevorzugten Ausführungsform von Verbindungen gemäß Formel (1), (2), (5) und (6) ist an jedem Benzolring die Summe der Indizes n + o = 0 oder 1, d. h. an jeden Benzolring ist maximal eine Gruppe Ar oder maximal ein Rest R¹ gebunden. Besonders bevorzugt ist o = 0.

Besonders bevorzugt enthalten die Verbindungen gemäß Formel (5) eine oder zwei Triazingruppen. Die Verbindungen gemäß Formel (5) sind also besonders bevorzugt ausgewählt aus Verbindungen gemäß Formel (7), (8) und (9), 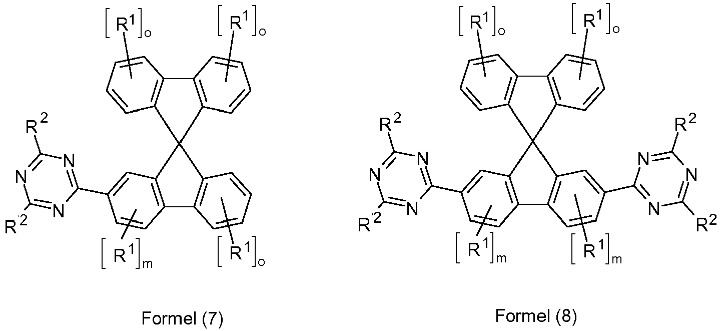 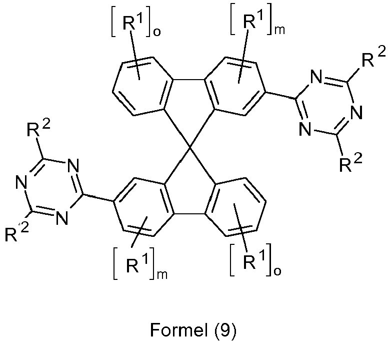 wobei die verwendeten Symbole die oben genannten Bedeutungen haben und o gleich oder verschieden bei jedem Auftreten für 0 oder 1, bevorzugt für 0, steht.

Die Verbindungen der Formel (6) sind bevorzugt gewählt aus den Verbindungen der Formel (10), 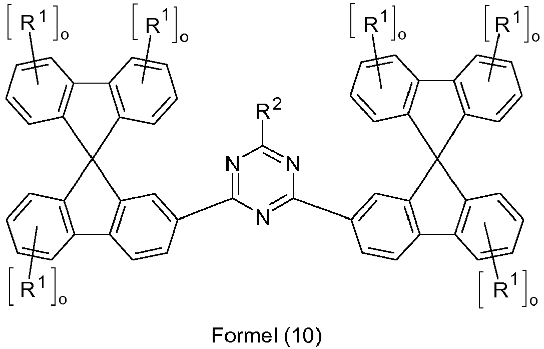 wobei die verwendeten Symbole die oben genannten Bedeutungen haben und o gleich oder verschieden bei jedem Auftreten für 0 oder 1, bevorzugt für 0, steht.

Besonders bevorzugt sind die Verbindungen gemäß den Formeln (7) bis (10), in denen R², welches an die Triazineinheit gebunden ist, gleich oder verschieden bei jedem Auftreten für ein aromatisches oder heteroaromatisches Ringsystem mit 5 bis 25 aromatischen Ringatomen steht, insbesondere für Phenyl, 1- oder 2-Naphthyl, ortho-, meta- oder para-Biphenyl oder 2-Spirobifluorenyl. Ganz besonders bevorzugt ist der Index o dabei gleich 0.

Beispiele für bevorzugte Verbindungen gemäß den Formeln (1), (2) und (5) bis (10) sind die im Folgenden abgebildeten Verbindungen 1 bis 69.

| | | |
|---|---|---|
| 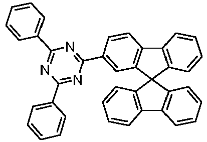 | 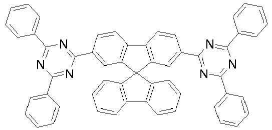 | 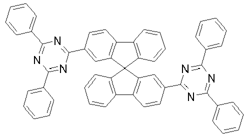 |
| 1 | 2 | 3 |
| 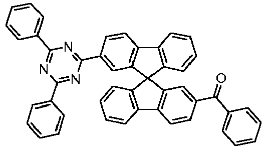 | 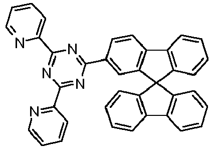 | 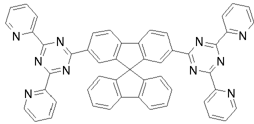 |
| 4 | 5 | 6 |
| 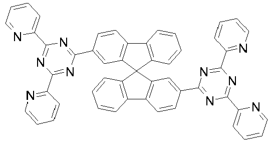 | 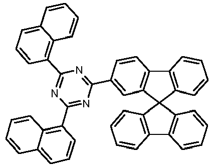 | 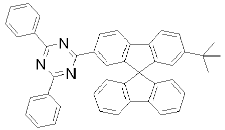 |
| 7 | 8 | 9 |
| 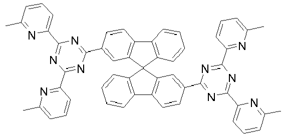 | 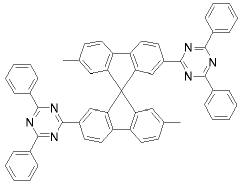 | 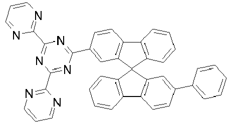 |
| 10 | 11 | 12 |
| 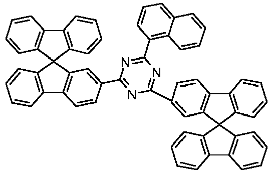 | 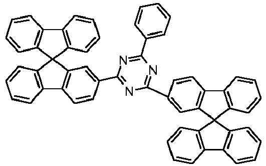 | 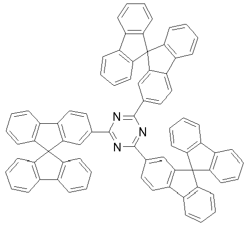 |
| 13 | 14 | 15 |
| 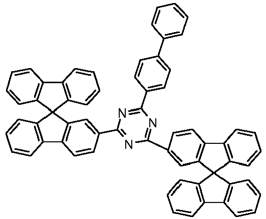 | 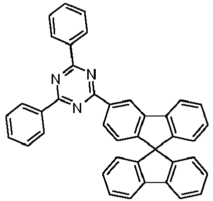 | 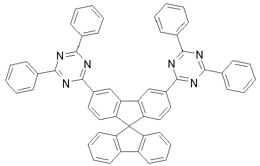 |
| 16 | 17 | 18 |
| 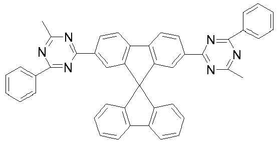 | 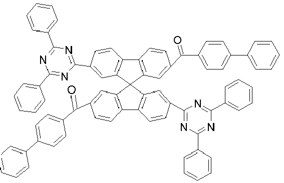 | 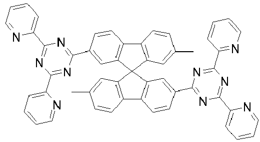 |
| 19 | 20 | 21 |
| 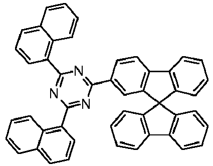 | 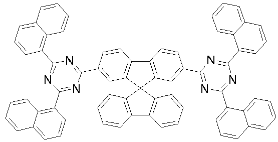 | 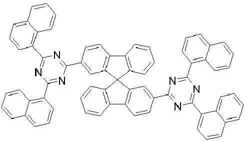 |
| 22 | 23 | 24 |
| 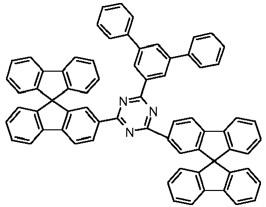 | 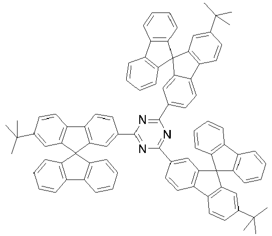 | 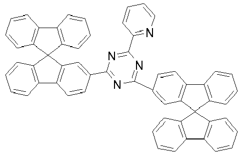 |
| 25 | 26 | 27 |
| 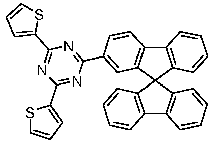 | 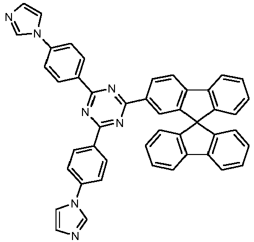 | 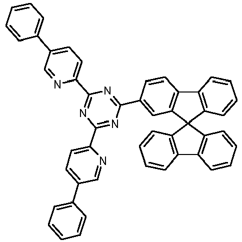 |
| 28 | 29 | 30 |
| 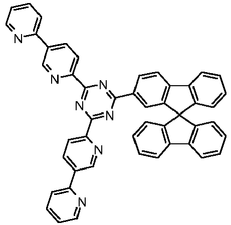 | 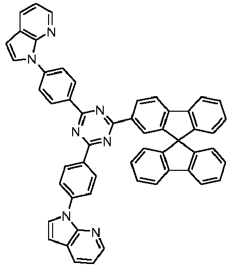 | 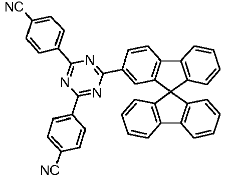 |
| 31 | 32 | 33 |
| 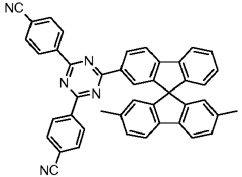 | 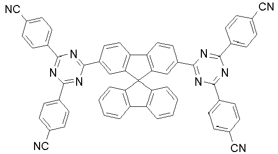 | 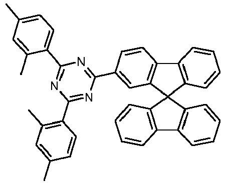 |
| 34 | 35 | 36 |
| 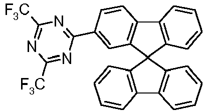 | 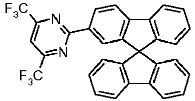 | 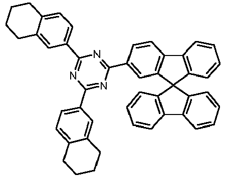 |
| 37 | 38 | 39 |
| 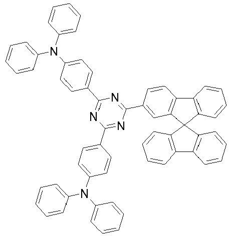 | 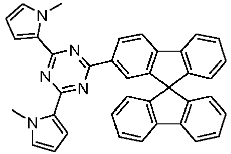 | 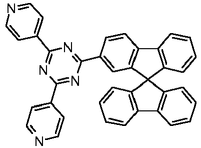 |
| 40 | 41 | 42 |
| 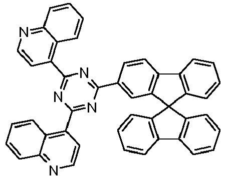 | 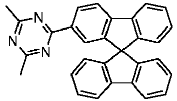 | 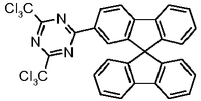 |
| 43 | 44 | 45 |
| 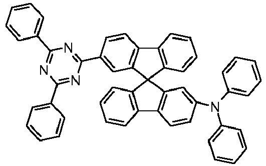 | 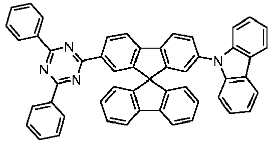 | 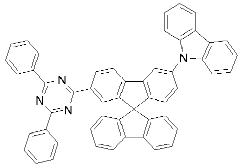 |
| 46 | 47 | 48 |
| 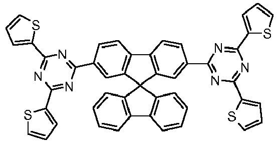 | 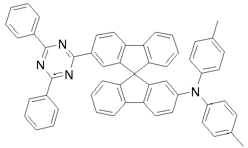 | 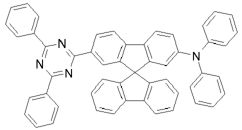 |
| 49 | 50 | 51 |
| 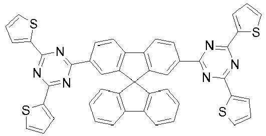 | 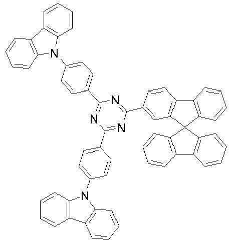 | 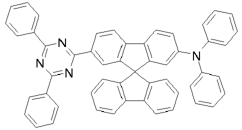 |
| 52 | 53 | 54 |
| 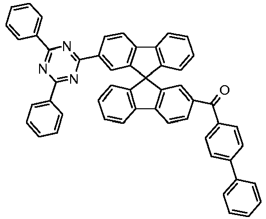 | 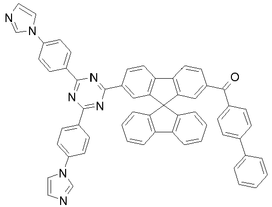 | 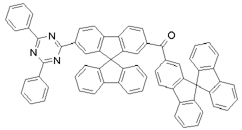 |
| 55 | 56 | 57 |
| 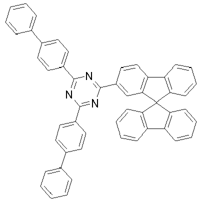 | 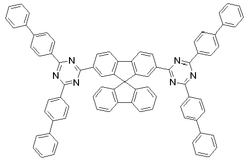 | 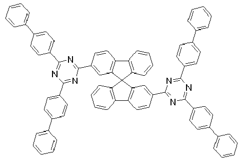 |
| 58 | 59 | 60 |
| 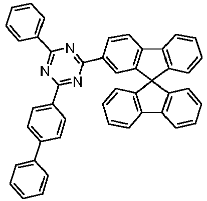 | 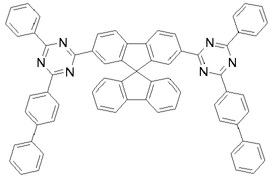 | 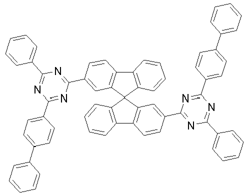 |
| 61 | 62 | 63 |
| 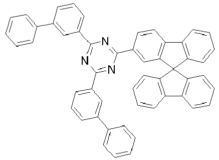 | 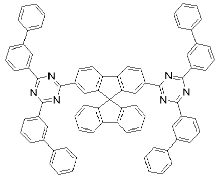 | 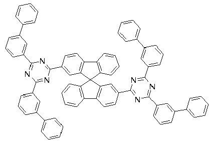 |
| 64 | 65 | 66 |
| 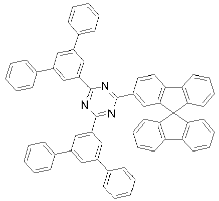 | 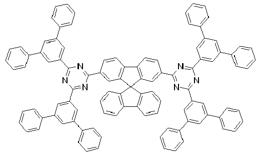 | 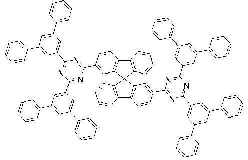 |
| 67 | 68 | 69 |

Als besonders vorteilhaft hat es sich weiterhin erwiesen, wenn die organische Elektrolumineszenzvorrichtung eine Elektronentransportschicht enthält, welche ein Triaryl-substituiertes Triazinderivat enthält, welches mit einer organischen Alkalimetallverbindung dotiert ist, oder wobei zwischen der Elektronentransportschicht enthaltend das Triaryltriazin und der Kathode eine weitere Schicht eingebracht ist, welche eine organische Alkalimetallverbindung enthält. Dabei kann das Triazin eine Verbindung der oben abgebildeten Formel (1) oder (2) sein, oder es kann eine andere aromatische Triazinverbindung sein.

Die organische Elektrolumineszenzvorrichtung kann eine Anode, Kathode, mindestens eine emittierende Schicht und mindestens eine Elektronentransportschicht, welche zwischen der emittierenden Schicht und der Kathode angeordnet ist enthalten, wobei die Elektronentransportschicht mindestens eine Verbindung der Formel (11) oder (12) enthält, 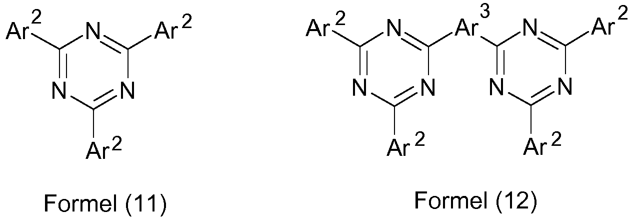 wobei R¹ die oben genannte Bedeutung hat und für die weiteren verwendeten Symbole gilt:
- Ar²: ist gleich oder verschieden bei jedem Auftreten ein monovalentes aromatisches oder heteroaromatisches Ringsystem mit 5 bis 60 aromatischen Ringatomen, welches jeweils mit einem oder mehreren Resten R¹ substituiert sein kann;
- Ar³: ist ein bivalentes aromatisches oder heteroaromatisches Ringsystem mit 5 bis 60 aromatischen Ringatomen, welches mit einem oder mehreren Resten R¹ substituiert sein kann;
dadurch gekennzeichnet, dass die Elektronentransportschicht mit einer organischen Alkalimetallverbindung dotiert ist oder dass zwischen die Elektronentransportschicht enthaltend die Verbindung gemäß Formel (11) bzw. (12) und die Kathode eine weitere Schicht eingebracht ist, welche eine organische Alkalimetallverbindung enthält.

Bevorzugt weisen die Verbindungen gemäß Formel (11) und (12) eine Glasübergangstemperatur T_{G} von größer als 70 °C auf, besonders bevorzugt größer als 90 °C, ganz besonders bevorzugt größer als 110 °C.

Bevorzugt ist in Verbindungen der Formel (11) mindestens eine Gruppe Ar² gewählt aus den Gruppen der folgenden Formeln (13) bis (27),

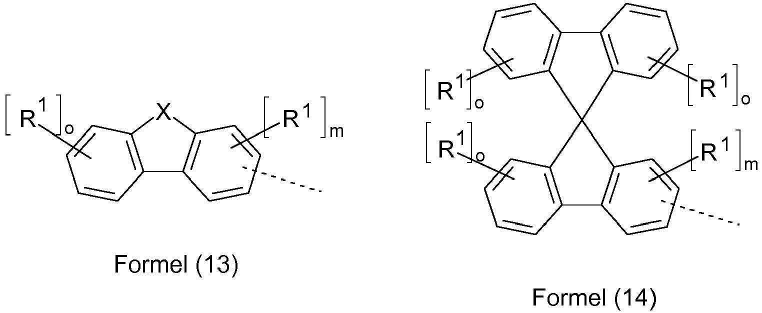

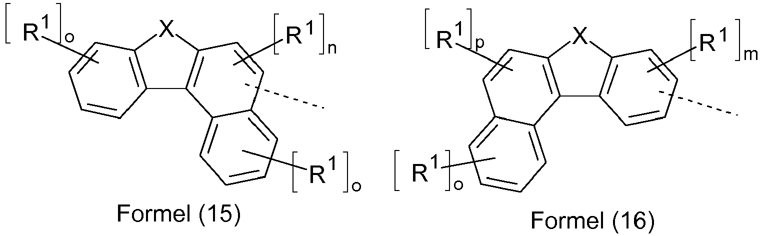

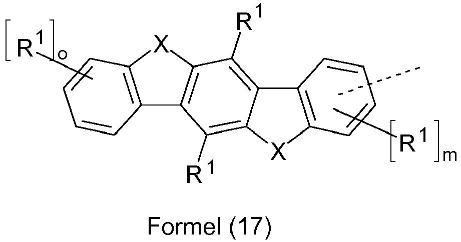

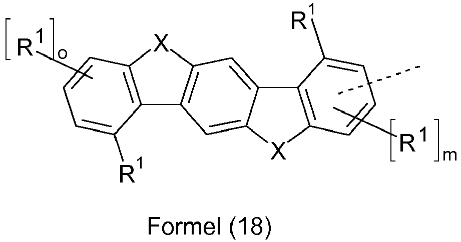

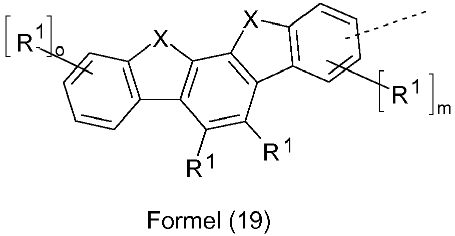

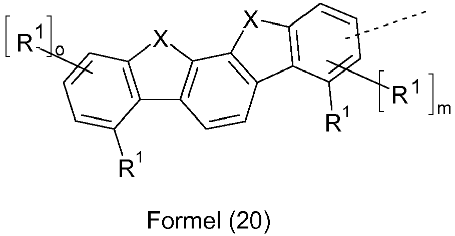

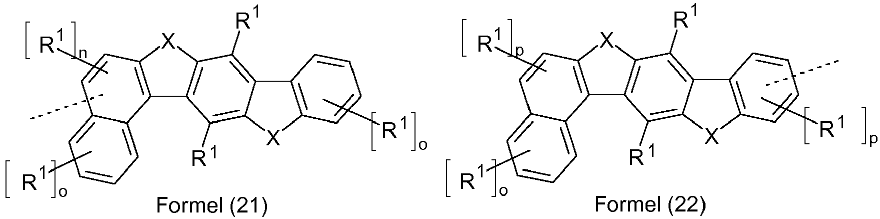

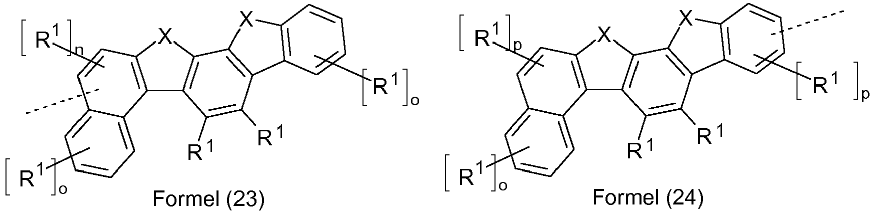

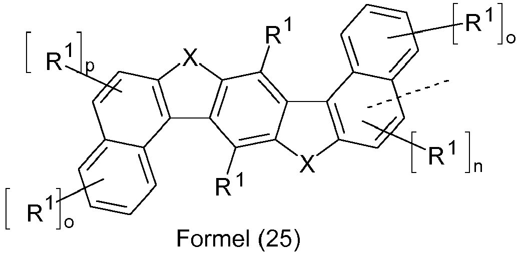

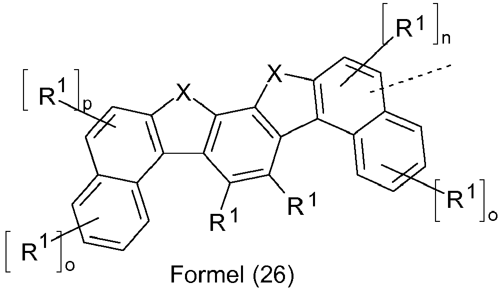

(Ar⁴)ₚ-(Ar⁵)_{q}-(Ar⁶)ᵣ---- Formel (27)

wobei R¹ dieselbe Bedeutung hat, wie oben beschrieben, die gestrichelte Bindung die Verknüpfung mit der Triazineinheit darstellt und weiterhin gilt:
- X: ist gleich oder verschieden bei jedem Auftreten eine bivalente Brücke, ausgewählt aus B(R¹), C(R¹)₂, Si(R¹)₂, C=O, C=NR¹, C=C(R¹)₂, O, S, S=O, SO₂,N(R¹), P(R¹) und P(=O)R¹;
- m: ist bei jedem Auftreten gleich oder verschieden 0, 1, 2 oder 3;
- o: ist bei jedem Auftreten gleich oder verschieden 0, 1, 2, 3 oder 4;
- Ar⁴, Ar⁶: ist gleich oder verschieden bei jedem Auftreten eine Aryl- oder Heteroarylgruppe mit 5 bis 18 aromatischen Ringatomen, welche durch einen oder mehrere Reste R¹ substituiert sein kann;
- Ar⁵: ist eine kondensierte Aryl- oder Heteroarylgruppe mit 10 bis 18 aromatischen Ringatomen, welche durch einen oder mehrere Reste R¹ substituiert sein kann;
- p, r: ist gleich oder verschieden bei jedem Auftreten 0, 1 oder 2, bevorzugt 0 oder 1;
- q: ist 1 oder 2, bevorzugt 1.

Besonders bevorzugt ist Ar⁵ in Formel (27) eine kondensierte Arylgruppe mit 10 bis 18 aromatischen C-Atomen, welche durch einen oder mehrere Reste R¹ substituiert sein kann. Besonders bevorzugt ist Ar⁵ gewählt aus der Gruppe bestehend aus Naphthalin, Anthracen, Phenanthren, Pyren, Benzanthracen und Chrysen, welche jeweils mit einem oder mehreren Resten R¹ substituiert sein können. Ganz besonders bevorzugt sind Anthracen und Benzanthracen.

Weiterhin bevorzugt ist, wenn die Gruppen Ar⁴ und Ar⁶ in Formel (27) gleich oder verschieden bei jedem Auftreten eine Aryl- oder Heteroarylgruppe mit 6 bis 14 aromatischen Ringatomen, welche jeweils durch einen oder mehrere Reste R¹ substituiert sein kann. Besonders bevorzugt sind Ar⁴ und Ar⁶ gleich oder verschieden bei jedem Auftreten gewählt aus der Gruppe bestehend aus Benzol, Pyridin, Pyrazin, Pyridazin, Pyrimidin, Triazin, Naphthalin, Chinolin, Isochinolin, Anthracen, Phenanthren, Phenanthrolin, Pyren, Benzanthracen und Chrysen, welche jeweils durch einen oder mehrere Reste R¹ substituiert sein können. Ganz besonders bevorzugt sind Ar⁴ und Ar⁶ ausgewählt aus der Gruppe bestehend aus Benzol und Naphthalin.

Besonders bevorzugte Gruppen Ar² sind gewählt aus den Gruppen der folgenden Formeln (13a) bis (26a), 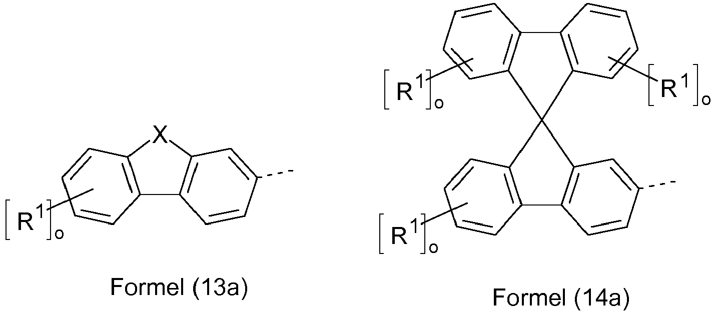 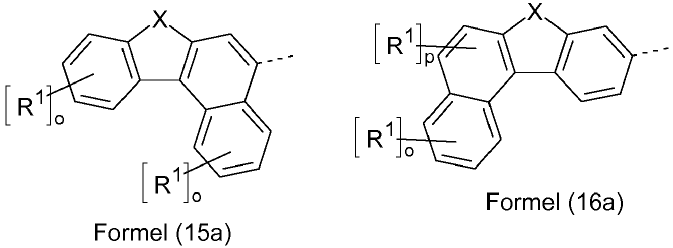 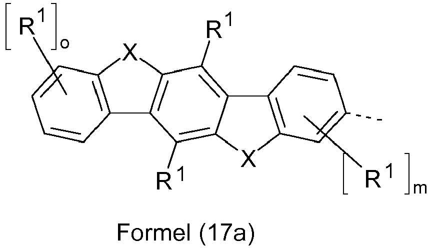 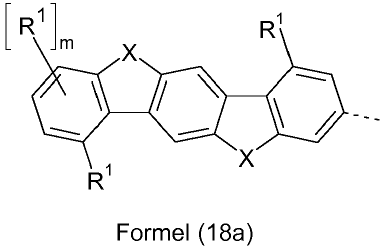 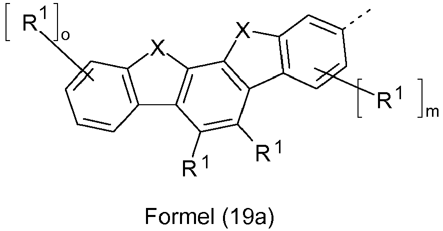 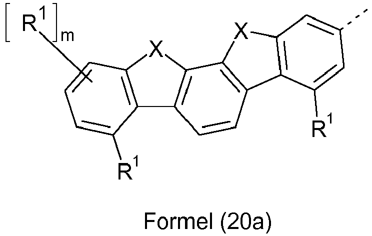 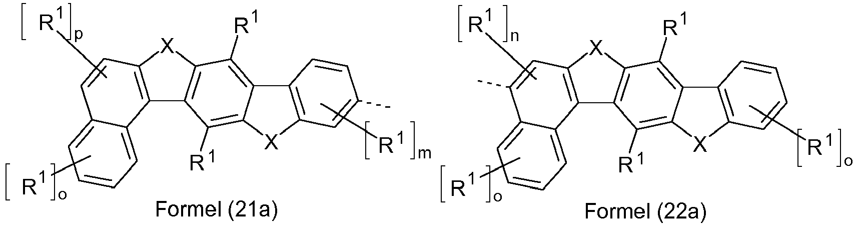 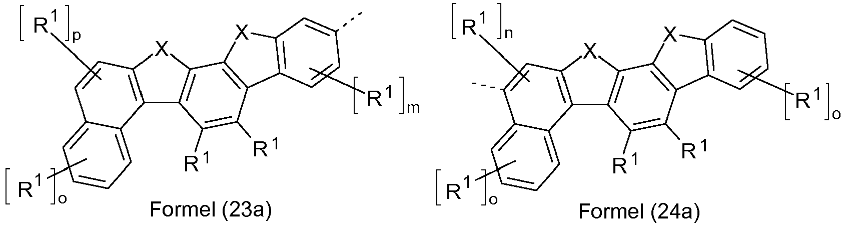 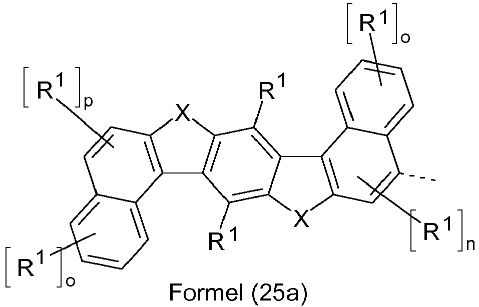 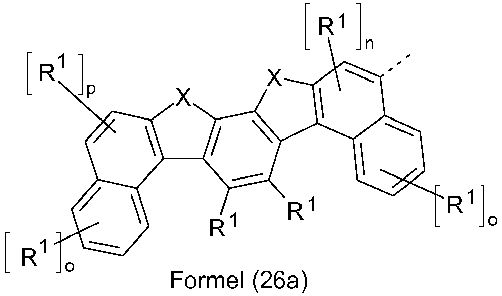 wobei die verwendeten Symbole und Indizes dieselbe Bedeutung haben, wie oben beschrieben. Dabei ist X bevorzugt gleich oder verschieden gewählt aus C(R¹)₂, N(R¹), O und S, besonders bevorzugt C(R¹)₂.

Weiterhin sind besonders bevorzugte Gruppen der Formel (27) die Gruppen der folgenden Formeln (27a) bis (27d), 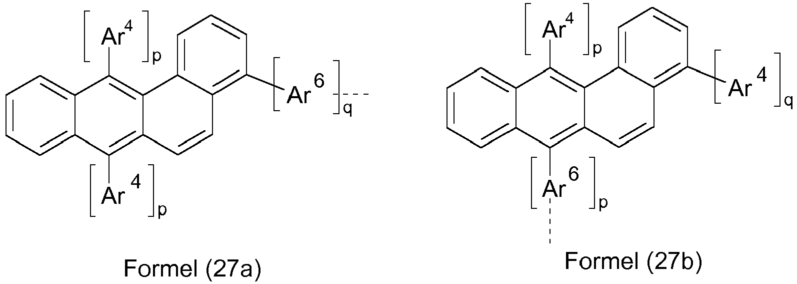 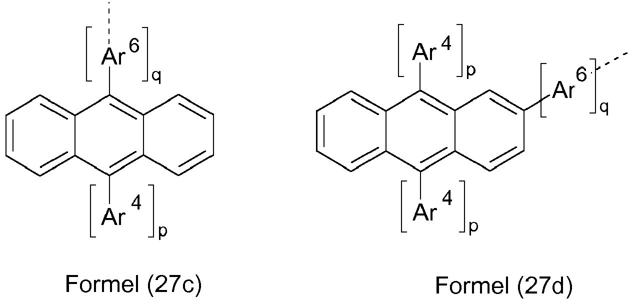 wobei diese Gruppen noch durch einen oder mehrere Reste R¹ substituiert sein können und wobei die verwendeten Symbole und Indizes die oben genannten Bedeutungen aufweisen und die gestrichelte Bindung die Bindung an das Triazin andeutet; dabei können die Gruppen gemäß Formel (27a) bis (27d) durch einen oder mehrere Reste R¹ substituiert sein und der Index p steht in Formel (27a) bis (27d) für 0 oder 1.

Bevorzugt sind auch Verbindungen der Formel (11), in der zwei oder drei Gruppen Ar² für eine Gruppe der oben aufgeführten Formeln (13) bis (27) stehen.

Bevorzugt sind weiterhin Verbindungen der oben aufgeführten Formel (11), in der eine Gruppe Ar² für eine Gruppe der oben aufgeführten Formeln (13) bis (27) steht und eine oder beide weitere Gruppen Ar² für Phenyl, 1- oder 2-Naphthyl, ortho-, meta- oder para-Biphenyl stehen, welche durch einen oder mehrere Reste R¹ substituiert sein können, jedoch bevorzugt unsubstituiert sind.

Bevorzugte Gruppen Ar³ in Verbindungen der Formel (12) sind gewählt aus den Gruppen der folgenden Formeln (28) bis (39), 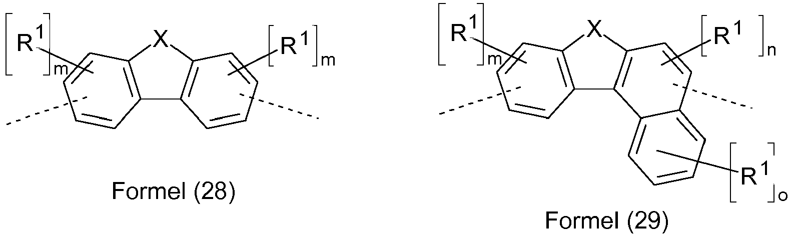 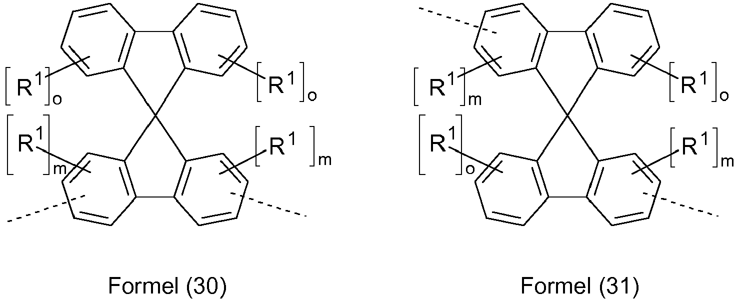 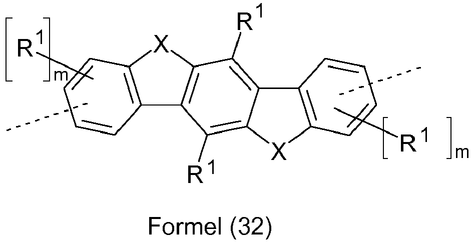 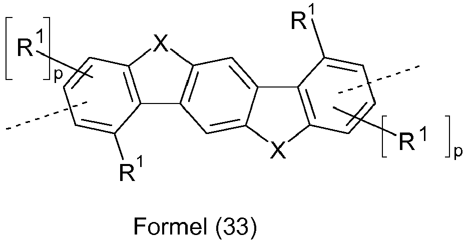 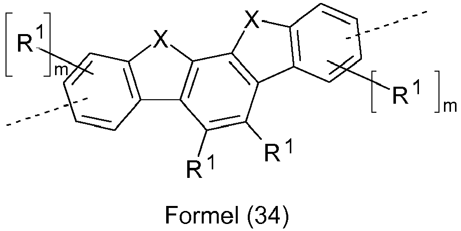 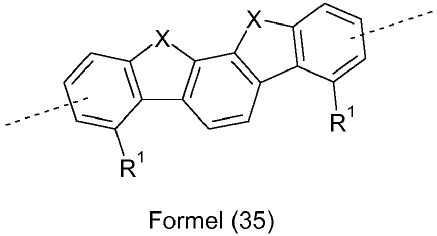 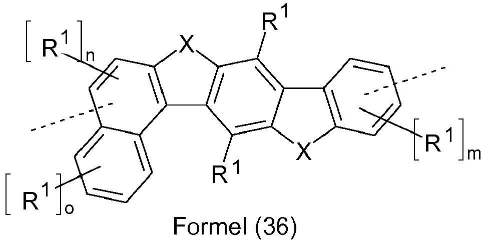 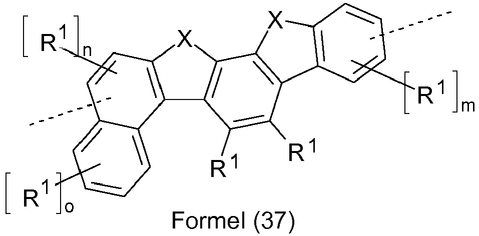 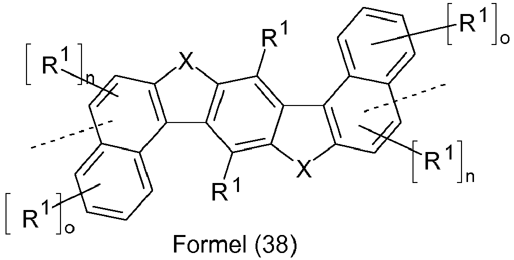 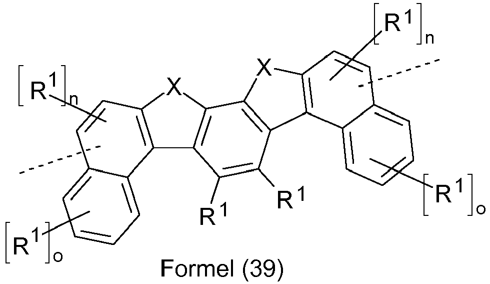 wobei die verwendeten Symbole und Indizes dieselbe Bedeutung haben, wie oben beschrieben und die gestrichelte Bindung die Verknüpfung mit den beiden Triazineinheiten darstellt.

Besonders bevorzugte Gruppen Ar³ sind gewählt aus den Gruppen der folgenden Formeln (28a) bis (39a), 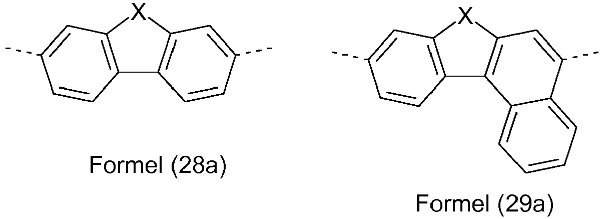 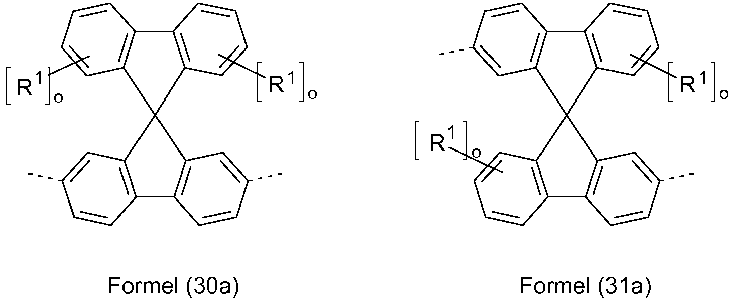 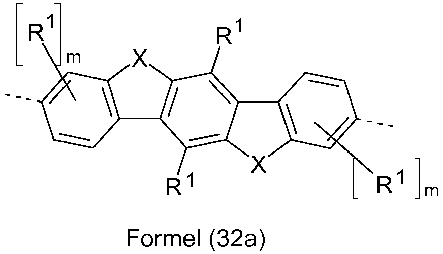 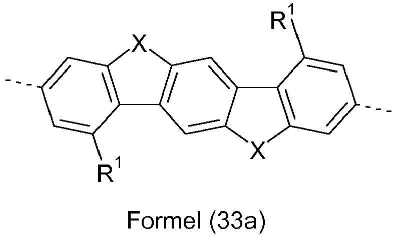 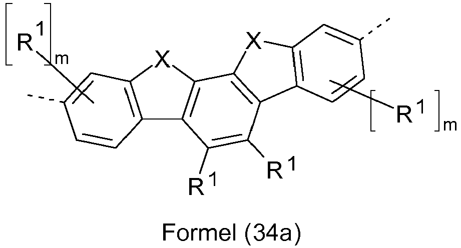 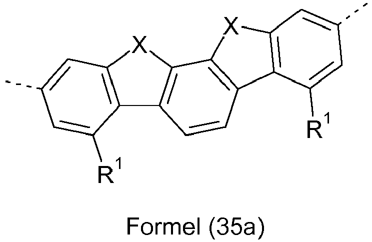 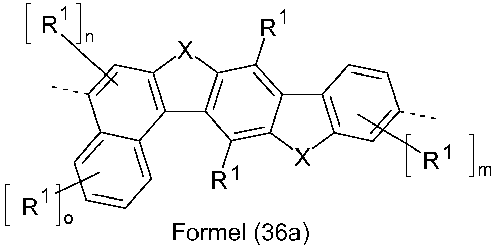 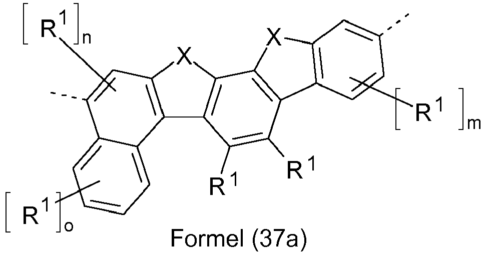 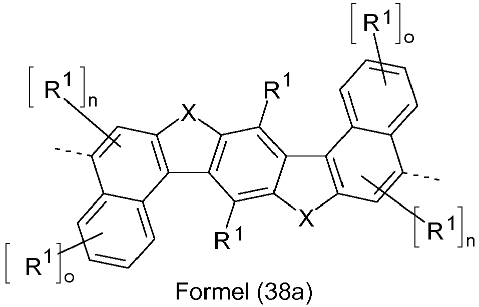 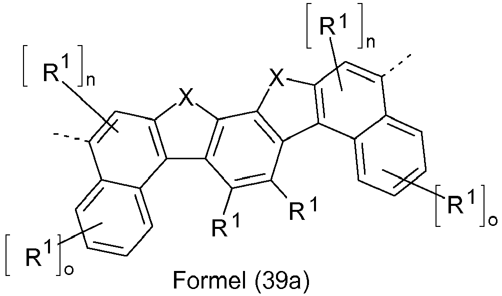 wobei die verwendeten Symbole und Indizes dieselbe Bedeutung haben, wie oben beschrieben. Dabei ist X bevorzugt gleich oder verschieden gewählt aus C(R¹)₂, N(R¹), O und S, besonders bevorzugt C(R¹)₂.

Bevorzugt sind weiterhin Verbindungen der oben aufgeführten Formel (12), in der die Gruppe Ar³ aus den oben aufgeführten Formeln (28) bis (39) ausgewählt ist und Ar² gleich oder verschieden bei jedem Auftreten ausgewählt ist aus den oben aufgeführten Formeln (13) bis (27) oder Phenyl, 1- oder 2-Naphthyl, ortho-, meta- oder para-Biphenyl, welche durch einen oder mehrere Reste R¹ substituiert sein können, jedoch bevorzugt unsubstituiert sind.

Beispiele für bevorzugte Verbindungen gemäß den Formeln (11) und (12) sind außer den oben abgebildeten Strukturen 1 bis 69 die folgenden Strukturen 70 bis 178:

| | | |
|---|---|---|
| 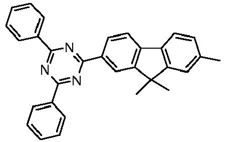 | 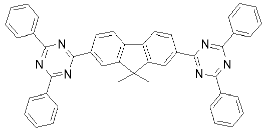 | 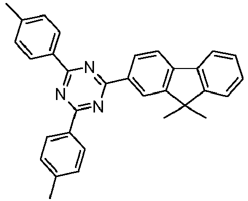 |
| 70 | 71 | 72 |
| 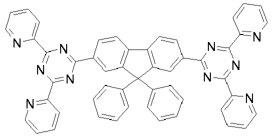 | 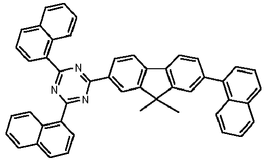 | 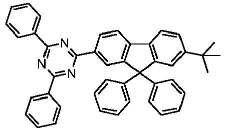 |
| 73 | 74 | 75 |
| 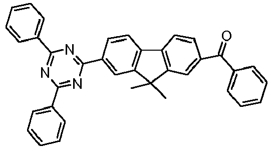 | 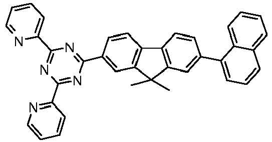 | 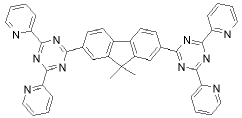 |
| 76 | 77 | 78 |
| 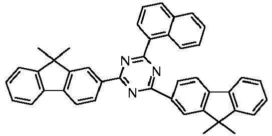 | 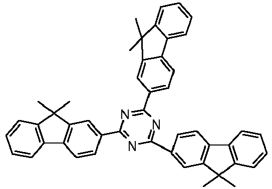 | 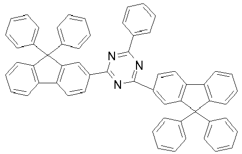 |
| 79 | 80 | 81 |
| 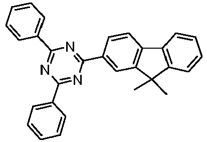 | 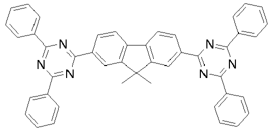 | 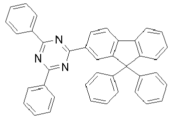 |
| 82 | 83 | 84 |
| 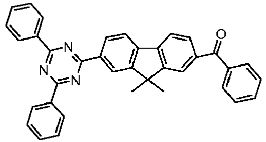 | 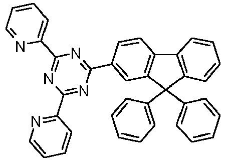 | 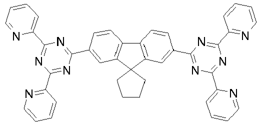 |
| 85 | 86 | 87 |
| 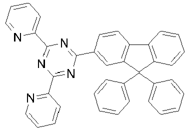 | 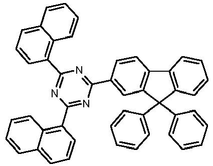 | 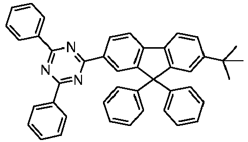 |
| 88 | 89 | 90 |
| 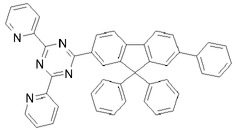 | 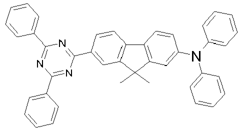 | 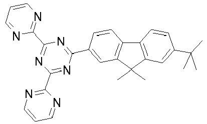 |
| 91 | 92 | 93 |
| 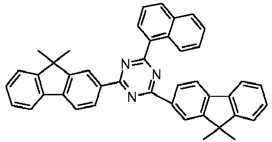 | 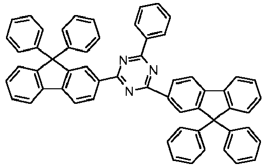 | 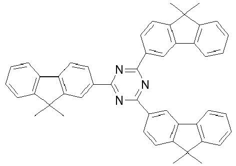 |
| 94 | 95 | 96 |
| 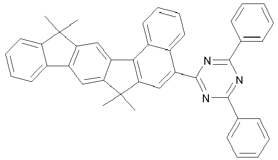 | 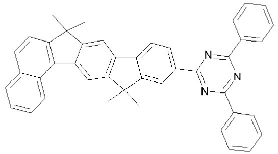 | 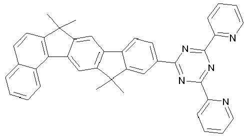 |
| 97 | 98 | 99 |
| 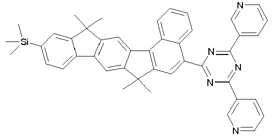 | 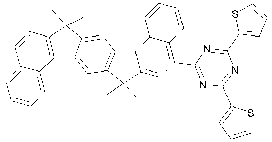 | 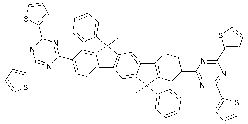 |
| 100 | 101 | 102 |
| 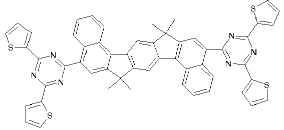 | 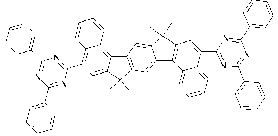 | 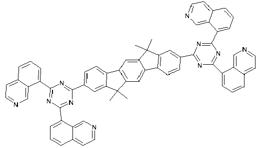 |
| 103 | 104 | 105 |
| 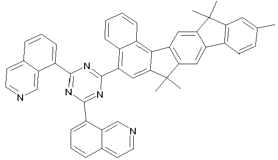 | 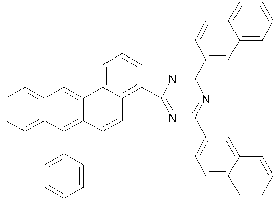 | 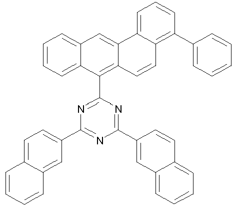 |
| 106 | 107 | 108 |
| 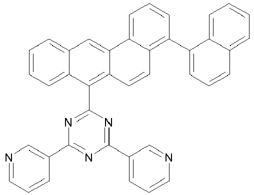 | 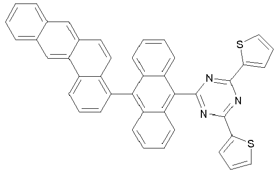 | 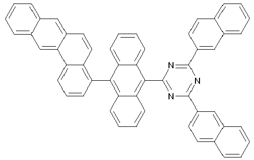 |
| 109 | 110 | 111 |
| 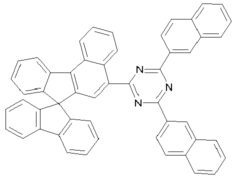 | 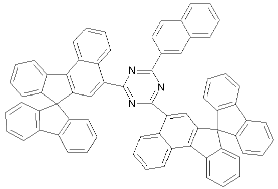 | 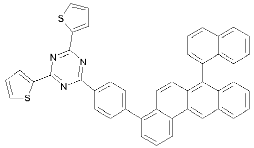 |
| 112 | 113 | 114 |
| 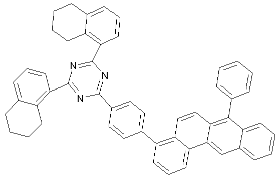 | 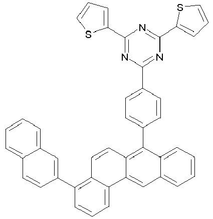 | 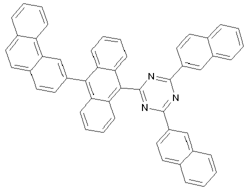 |
| 115 | 116 | 117 |
| 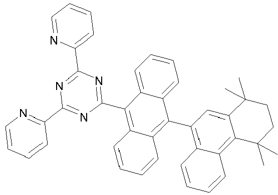 | 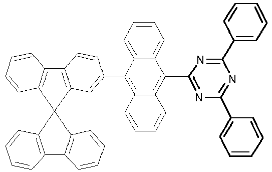 | 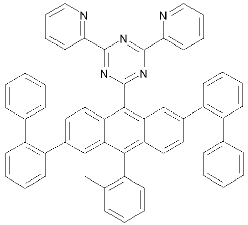 |
| 118 | 119 | 120 |
| 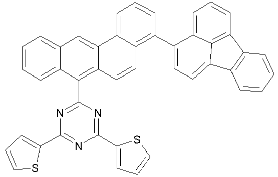 | 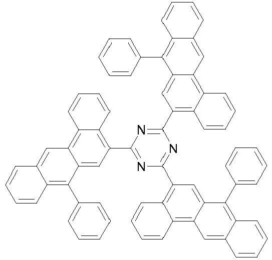 | 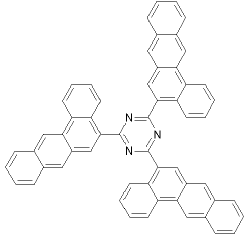 |
| 121 | 122 | 123 |
| 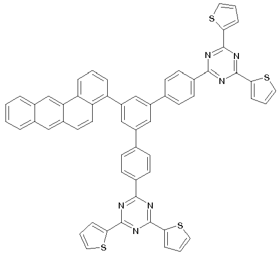 | 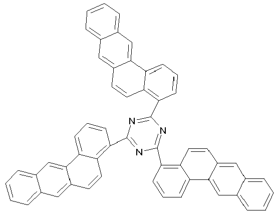 | 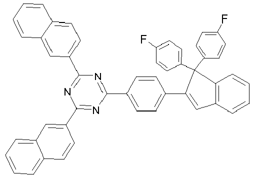 |
| 124 | 125 | 126 |
| 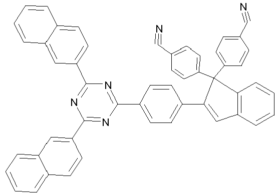 | 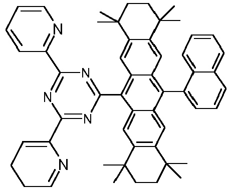 | 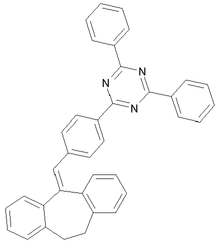 |
| 127 | 128 | 129 |
| 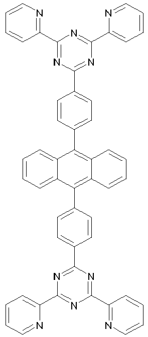 | 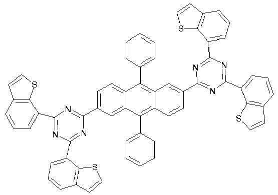 | 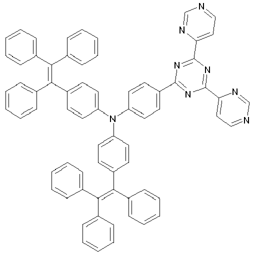 |
| 130 | 131 | 132 |
| 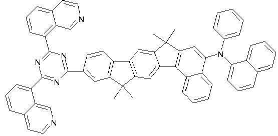 | 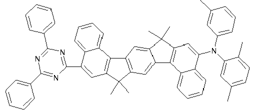 | 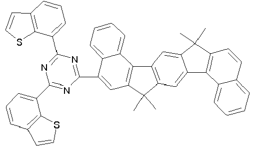 |
| 133 | 134 | 135 |
| 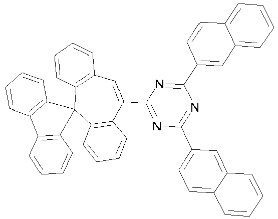 | 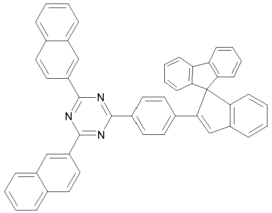 | 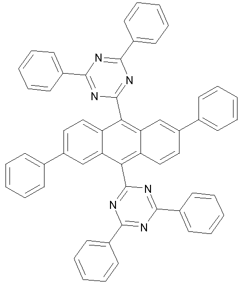 |
| 136 | 137 | 138 |
| 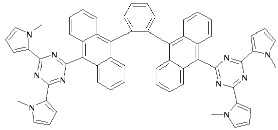 | 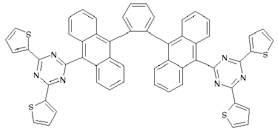 | 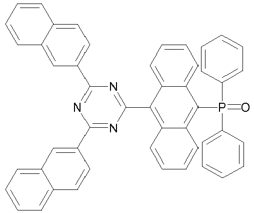 |
| 139 | 140 | 141 |
| 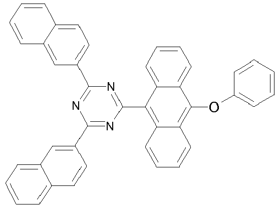 | 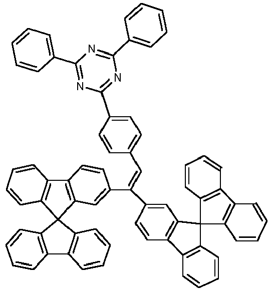 | 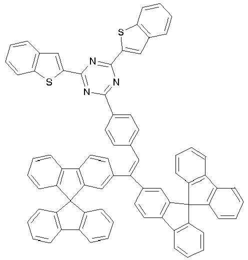 |
| 142 | 143 | 144 |
| 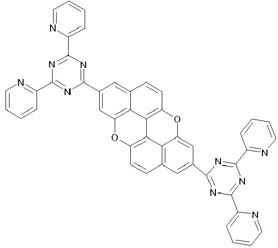 | 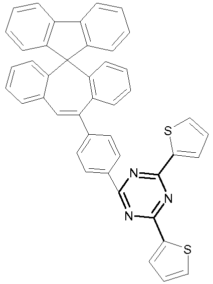 | 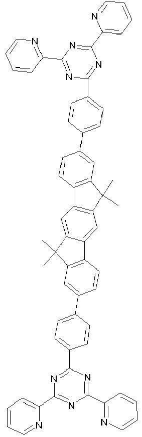 |
| 145 | 146 | 147 |
| 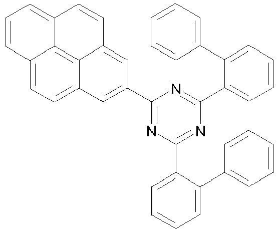 | 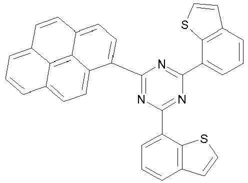 | 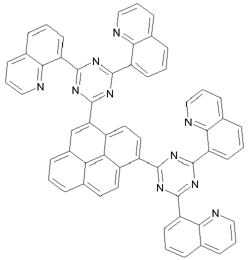 |
| 148 | 149 | 150 |
| 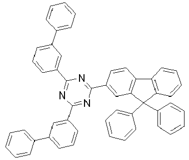 | 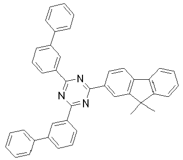 | 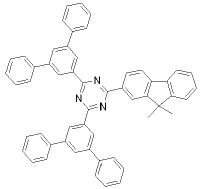 |
| 151 | 152 | 153 |
| 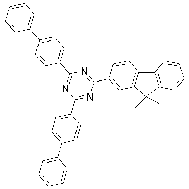 | 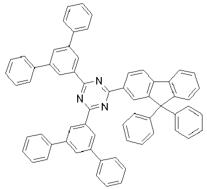 | 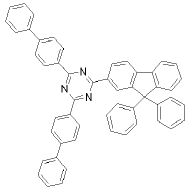 |
| 154 | 155 | 156 |
| 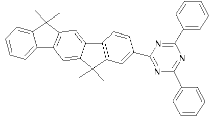 | 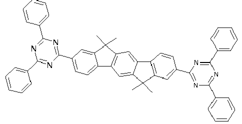 | 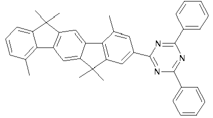 |
| 157 | 158 | 159 |
| 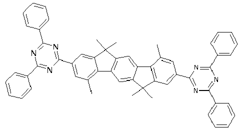 | 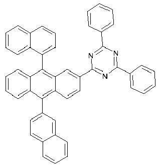 | 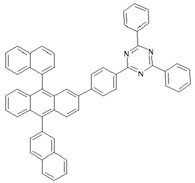 |
| 160 | 161 | 162 |
| 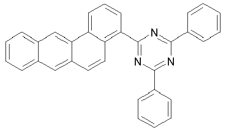 | 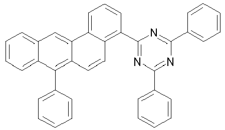 | 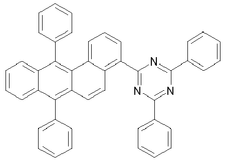 |
| 163 | 164 | 165 |
| 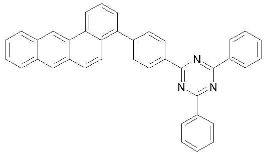 | 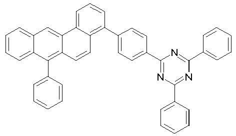 | 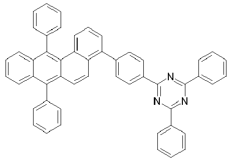 |
| 166 | 167 | 168 |
| 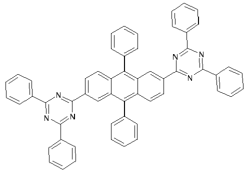 | 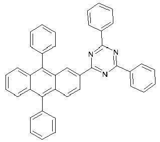 | 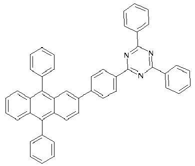 |
| 169 | 170 | 171 |
| 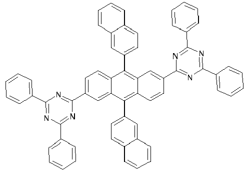 | 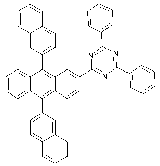 | 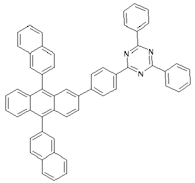 |
| 172 | 173 | 174 |
| 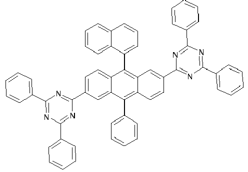 | 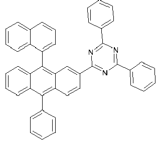 | 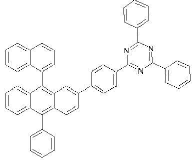 |
| 175 | 176 | 177 |
| 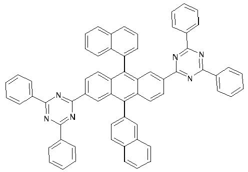 | | |
| 178 | | |

Die oben genannten Triazin-Verbindungen können beispielsweise gemäß den in US 6,229,012, US 6,225,467, WO 05/053055 und in der nicht offen gelegten Anmeldung DE 102008036982.9 beschriebenen Verfahren synthetisiert werden. Allgemein eignen sich nucleophile aromatische Substitutionsreaktionen und metallkatalysierte Kupplungsreaktionen, insbesondere die Suzuki-Kupplung, zur Synthese der Verbindungen wie im folgenden Schema 1 am Beispiel des Triazins dargestellt. So kann beispielsweise eine aromatische Grignard-Verbindung in einer nucleophilen aromatischen Substitutionsreaktion mit 1,3,5-Trichlortriazin reagieren, wobei je nach stöchiometrischem Verhältnis das Monoaryl-, Diaryl- oder Triaryltriazin entsteht. Weiterhin kann beispielsweise eine aromatische Verbindung, welche jeweils mit einer Boronsäure oder einem Boronsäurederivat substituiert ist, unter Palladium-Katalyse mit dem Triazin gekuppelt werden, welche für Verbindungen gemäß Formel (1) bzw. (11) mit einer reaktiven Abgangsgruppe und für Verbindungen gemäß Formel (2) bzw. (12) mit zwei reaktiven Abgangsgruppen substituiert ist. Geeignete reaktive Abgangsgruppen sind beispielsweise Halogene, insbesondere Chlor, Brom und lod, Triflat oder Tosylat. Als weitere Synthesemethode eignet sich die Trimerisierung von aromatischen Nitrilen. Diese Synthesemethoden sind dem Fachmann der organischen Synthese generell bekannt und können von ihm ohne erfinderisches Zutun für die Triazin-Verbindungen der Formeln (11) und (12) angewandt werden.

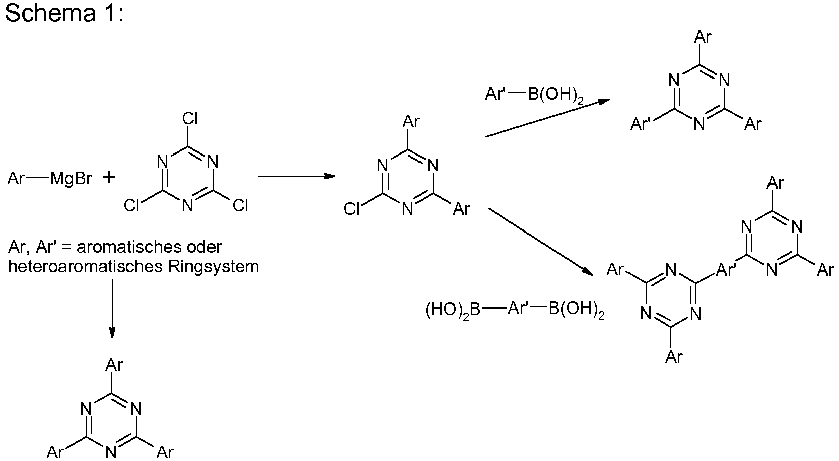

Die oben genannten Triazin-Derivate werden erfindungsgemäß in Kombination mit einer organischen Alkalimetallverbindung in der Elektronentransportschicht einer organischen Elektrolumineszenzvorrichtung eingesetzt. Dabei bedeutet "in Kombination mit einer organischen Alkalimetallverbindung", dass das Triazin-Derivat und die Alkalimetallverbindung entweder als Mischung in einer Schicht oder separat in zwei aufeinander folgenden Schichten vorliegen. In einer bevorzugten Ausführungsform der Erfindung liegen das Triazin-Derivat und die organische Alkalimetallverbindung als Mischung in einer Schicht vor.

Unter einer organischen Alkalimetallverbindung im Sinne dieser Erfindung soll eine Verbindung verstanden werden, welche mindestens ein Alkalimetall, also Lithium, Natrium, Kalium, Rubidium oder Caesium, enthält und welche weiterhin mindestens einen organischen Liganden enthält.

Geeignete organische Alkalimetallverbindungen sind beispielsweise die in WO 07/050301, WO 07/050334 und EP 1144543 offenbarten Verbindungen. Diese sind via Zitat Bestandteil der vorliegenden Anmeldung.

Bevorzugte organische Alkalimetallverbindungen sind die Verbindungen der folgenden Formel (40), 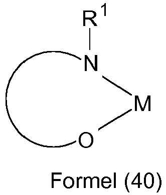 wobei R¹ dieselbe Bedeutung hat, wie oben beschrieben, die gebogene Linie zwei oder drei Atome und Bindungen darstellt, welche erforderlich sind, um mit M einen 5- oder 6-Ring zu ergänzen, wobei diese Atome auch durch einen oder mehrere Reste R¹ substituiert sein können, und M ein Alkalimetall, ausgewählt aus Lithium, Natrium, Kalium, Rubidium oder Caesium, darstellt.

Dabei ist es möglich, dass der Komplex gemäß Formel (40) in monomerer Form vorliegt, wie oben abgebildet, oder dass er in Form von Aggregaten vorliegt, beispielsweise aus zwei Alkalimetallionen und zwei Liganden, vier Alkalimetallionen und vier Liganden, sechs Alkalimetallionen und sechs Liganden oder andere Aggregate.

Bevorzugte Verbindungen der Formel (40) sind die Verbindungen der folgenden Formeln (41) und (42), 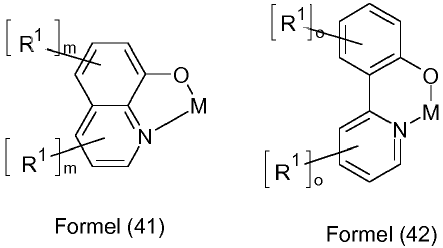 wobei die verwendeten Symbole und Indizes die oben genannten Bedeutungen haben.

Weitere bevorzugte organische Alkalimetallverbindungen sind die Verbindungen gemäß der folgenden Formel (43), 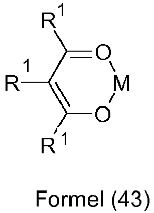 wobei die verwendeten Symbole dieselbe Bedeutung haben, wie oben beschrieben.

Bevorzugt ist das Alkalimetall gewählt aus Lithium, Natrium und Kalium, besonders bevorzugt Lithium und Natrium, ganz besonders bevorzugt Lithium.

Besonders bevorzugt ist eine Verbindung der Formel (41), insbesondere mit M = Lithium. Ganz besonders bevorzugt sind weiterhin die Indizes m = 0. Ganz besonders bevorzugt handelt es sich also um unsubstituiertes Lithiumchinolinat.

Ganz besonders bevorzugt enthält die organische Elektrolumineszenzvorrichtung eine Mischung aus einer Triazinverbindung, gewählt aus den Verbindungen der oben genannten Formeln (7) bis (10), insbesondere mit o = 0 und R² gleich Phenyl, 1- oder 2-Naphthyl, ortho-, meta- oder para-Biphenyl oder 2-Spirobifluorenyl, und einer organischen Alkalimetallverbindung der Formel (41), bevorzugt mit M = Lithium, insbesondere unsubsubstituiertes Lithiumchinolinat.

Beispiele für geeignete organische Alkalimetallverbindungen sind die in der folgenden Tabelle aufgeführten Strukturen 179 bis 223.

| | | |
|---|---|---|
| 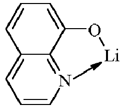 | 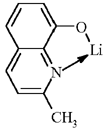 | 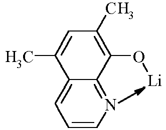 |
| 179 | 180 | 181 |
| 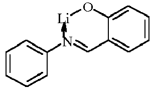 | 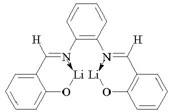 | 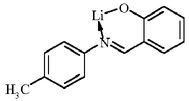 |
| 182 | 183 | 184 |
| 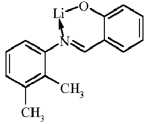 | 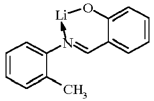 | 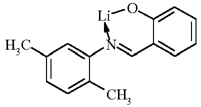 |
| 185 | 186 | 187 |
| 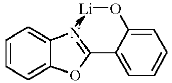 | 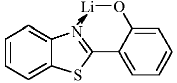 | 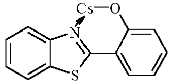 |
| 188 | 189 | 190 |
| 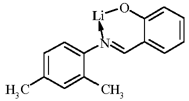 | 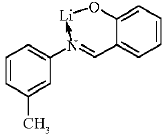 | 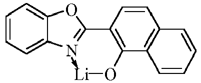 |
| 191 | 192 | 193 |
| 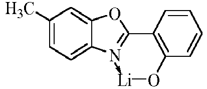 | 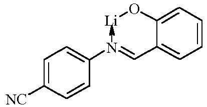 | 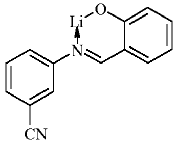 |
| 194 | 195 | 196 |
| 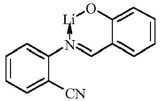 | 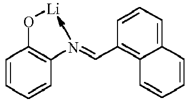 | 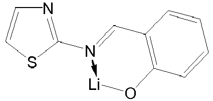 |
| 197 | 198 | 199 |
| 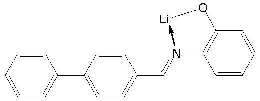 | 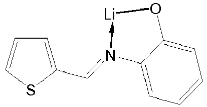 | 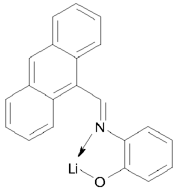 |
| 200 | 201 | 202 |
| 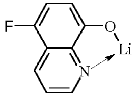 | 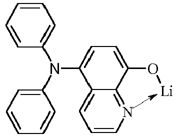 | 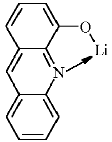 |
| 203 | 204 | 205 |
| 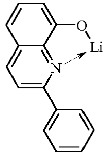 | 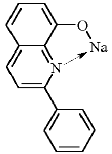 | 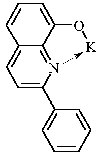 |
| 206 | 207 | 208 |
| 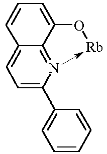 | 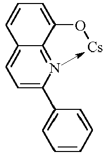 | 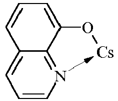 |
| 209 | 210 | 211 |
| 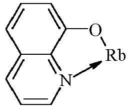 | 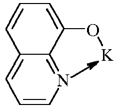 | 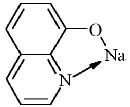 |
| 212 | 213 | 214 |
| 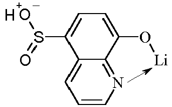 | 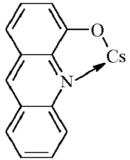 | 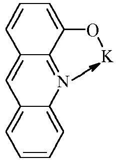 |
| 215 | 216 | 217 |
| 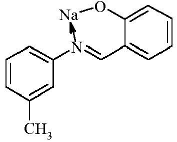 | 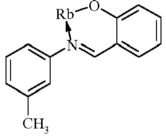 | 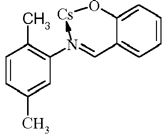 |
| 218 | 219 | 220 |
| 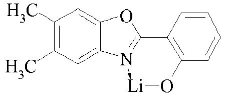 | 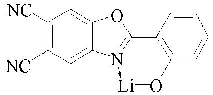 | 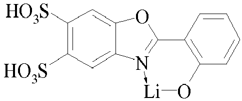 |
| 221 | 222 | 223 |

Wenn die Triazinverbindung und die organische Alkalimetallverbindung in einer Mischung vorliegen, beträgt das Verhältnis der Triazinverbindung gemäß Formel (11) bzw. (12) zur organischen Alkalimetallverbindung bevorzugt 20:80 bis 80:20, besonders bevorzugt 30:70 bis 70:30, ganz besonders bevorzugt 30:70 bis 50:50, insbesondere 30:70 bis 45:55. Besonders bevorzugt liegt also die organischen Alkalimetallverbindung in höherem Anteil vor als die Triazinverbindung gemäß Formel (11) oder (12).

Wenn die Triazinverbindung und die organische Alkalimetallverbindung in einer Mischung vorliegen beträgt die Schichtdicke dieser Elektronentransportschicht bevorzugt zwischen 3 und 150 nm, besonders bevorzugt zwischen 5 und 100 nm, ganz besonders bevorzugt zwischen 10 und 60 nm, insbesondere zwischen 15 und 40 nm.

Wenn die Triazinverbindung und die organische Alkalimetallverbindung in zwei aufeinanderfolgenden Schichten vorliegen, so beträgt die Schichtdicke der Schicht, welche die Triazinverbindung gemäß Formel (11) bzw. (12) enthält, bevorzugt zwischen 3 und 150 nm, besonders bevorzugt zwischen 5 und 100 nm, ganz besonders bevorzugt zwischen 10 und 60 nm, insbesondere zwischen 15 und 40 nm. Die Schichtdicke der Schicht, welche die organische Alkalimetallverbindung enthält und welche zwischen der Triazinschicht und der Kathode angeordnet ist, beträgt bevorzugt zwischen 0.5 und 20 nm, besonders bevorzugt zwischen 1 und 10 nm, ganz besonders bevorzugt zwischen 1 und 5 nm, insbesondere zwischen 1.5 und 3 nm.

Dabei kann die emittierende Schicht eine fluoreszierende oder phosphoreszierende Schicht sein. Generell eignen sich alle bekannten emittierenden Materialien und Schichten in Kombination mit der erfindungsgemäßen Elektronentransportschicht und der Fachmann kann ohne erfinderisches Zutun beliebige emittierende Schichten mit der erfindungsgemäßen Elektronentransportschicht kombinieren.

Außer Kathode, Anode, einer oder mehreren emittierenden Schichten und der erfindungsgemäßen Elektronentransportschicht kann die organische Elektrolumineszenzvorrichtung noch weitere Schichten enthalten. Diese sind beispielsweise gewählt aus jeweils einer oder mehreren Lochinjektionsschichten, Lochtransportschichten, Lochblockierschichten, Elektroneninjektionsschichten, Elektronenblockierschichten, Excitonenblockierschichten, Charge-Generation Layers (IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer*)* und/oder organischen oder anorganischen p/n-Übergängen. Außerdem können Interlayers vorhanden sein, welche die Ladungsbalance im Device steuern. Weiterhin können die Schichten, insbesondere die Ladungstransportschichten, auch dotiert sein. Die Dotierung der Schichten kann für einen verbesserten Ladungstransport vorteilhaft sein. Es sei aber darauf hingewiesen, dass nicht notwendigerweise jede dieser Schichten vorhanden sein muss und die Wahl der Schichten immer von den verwendeten Verbindungen abhängt.

In einer weiteren bevorzugten Ausführungsform der Erfindung enthält die organische Elektrolumineszenzvorrichtung mehrere emittierende Schichten. Besonders bevorzugt weisen diese Emissionsschichten insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können und die blaues und gelbes, orange oder rotes Licht emittieren. Insbesondere bevorzugt sind Dreischichtsysteme, also Systeme mit drei emittierenden Schichten, wobei die drei Schichten blaue, grüne und orange oder rote Emission zeigen (für den prinzipiellen Aufbau siehe z. B. WO 05/011013). Auch die Verwendung von mehr als drei emittierenden Schichten kann bevorzugt sein. Ebenso eignen sich für weiße Emission Emitter, welche breitbandige Emissionsbanden aufweisen und dadurch weiße Emission zeigen.

Die erfindungsgemäßen Elektronentransportschichten können mit beliebigen Kathodenmaterialien, wie sie gemäß dem Stand der Technik verwendet werden, eingesetzt werden. Beispiele für besonders geeignete Kathodenmaterialien sind allgemein Metalle mit einer niedrigen Austrittsarbeit, gefolgt von einer Schicht Aluminium oder einer Schicht Silber. Beispiele hierfür sind Caesium, Barium, Calcium, Ytterbium und Samarium, jeweils gefolgt von einer Schicht Aluminium oder Silber. Weiterhin geeignet ist eine Legierung aus Magnesium und Silber. Weiterhin geeignet ist reines Aluminium.

Es ist weiterhin möglich, zwischen die erfindungsgemäße Elektronentransportschicht und die Kathode eine Elektroneninjektionsschicht einzubringen. Geeignete Materialien für die Elektroneninjektionsschicht sind beispielsweise LiF, Lithiumchinolinat, CsF, CS₂CO₃, Li₂O, LiBO₂, K₂SiO₃, CS₂O oder Al₂O₃.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es sei jedoch angemerkt, dass der Druck auch noch geringer sein kann, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig. Hohe Löslichkeit lässt sich durch geeignete Substitution der Verbindungen erreichen. Dabei können nicht nur Lösungen aus einzelnen Materialien aufgebracht werden, sondern auch Lösungen, die mehrere Verbindungen enthalten, beispielsweise Matrixmaterialien und Dotanden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht aus Lösung aufzubringen und darauf eine Elektronentransportschicht enthaltend eine Verbindung gemäß Formel (1), (2), (11) oder (12), ggf. in Kombination mit einer organischen Alkalimetallverbindung, im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1), (2), (11) oder (12) bzw. die oben aufgeführten bevorzugten Ausführungsformen angewandt werden.

Mischungen können mindestens eine Verbindung gemäß Formel (11) oder (12) und mindestens eine organische Alkalimetallverbindung enthalten. Dabei sind die Verbindungen gemäß Formel (11) bzw. (12) bevorzugt gewählt aus den oben genannten bevorzugten Verbindungen. Die organische Alkalimetallverbindung ist dabei bevorzugt gewählt aus den Verbindungen der oben aufgeführten Formel (40) bis (43).

Verbindungen gemäß Formel (11) oder Formel (12) können als Elektronentransportmaterial in einer Elektronentransportschicht in einer organischen Elektrolumineszenzvorrichtung in Kombination mit einer organischen Alkalimetallverbindung. Dabei sind die Verbindungen gemäß Formel (11) bzw. (12) bevorzugt gewählt aus den oben genannten bevorzugten Verbindungen. Die organische Alkalimetallverbindung ist dabei bevorzugt gewählt aus den Verbindungen der oben aufgeführten Formel (40) bis (43).

Die erfindungsgemäßen organischen Elektrolumineszenzvorrichtungen weisen folgende überraschende Vorteile gegenüber dem Stand der Technik auf:
1. Die erfindungsgemäßen organischen Elektrolumineszenzvorrichtungen weisen eine sehr hohe Effizienz auf. Die verbesserte Effizienz ist möglicherweise auf eine verbesserte Elektroneninjektion aus der Elektronentransportschicht in die emittierende Schicht zurückzuführen.
2. Die erfindungsgemäßen organischen Elektrolumineszenzvorrichtungen weisen gleichzeitig eine vergleichbare Lebensdauer auf.
3. Die erfindungsgemäßen organischen Elektrolumineszenzvorrichtungen weisen gleichzeitig eine verringerte Betriebsspannung auf. Die verringerte Betriebsspannung ist möglicherweise auf eine verbesserte Elektroneninjektion aus der Elektronentransportschicht in die emittierende Schicht zurückzuführen.

Die Erfindung wird durch die nachfolgenden Beispiele genauer beschrieben, ohne sie dadurch einschränken zu wollen. Der Fachmann kann, ohne erfinderisch tätig zu werden, weitere erfindungsgemäße Verbindungen herstellen und diese in organischen elektronischen Vorrichtungen verwenden.

### Beispiele

Die nachfolgenden Synthesen werden, sofern nicht anders angegeben, unter einer Schutzgasatmosphäre in getrockneten Lösungsmitteln durchgeführt. Die Edukte können von ALDRICH (Tri-*o*-tolylphosphin, Palladium(ll)acetat) bezogen werden. Spiro-9,9'-bifluoren-2-boronsäure kann nach der nicht offengelegten Anmeldung DE 102008036982.9 dargestellt werden. 2-Chlorocarbonyl-2',7'-dibrom-spiro-9,9'-bifluoren kann gemäß J. Org. Chem. 2006, 71, 456-465 dargestellt werden.

### Beispiel 1: Synthese von 2-(4,6-Bis-[3,1';5,1"]-terphen-1-yl)-1,3,5-triazin-2-yl)-spiro-9,9'-bifluoren

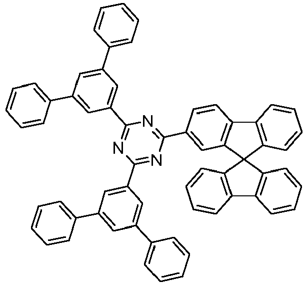

### a) Synthese von 2-Chlor-(4,6-bis-[3,1';5,1"]-terphen-1-yl)-1,3,5-triazin

Zu einer auf -78 °C gekühlten Lösung von 50.30 g (163 mmol) 1 -Brom-[3,1';5,1"]-terphen-1-yl in 400 mL abs. Tetrahydrofuran wurden 82.6 mL einer 2.0 molaren Lösung von n-Butyllithium in Hexan langsam hinzugetropft und 15 min lang gerührt. Die Reaktionslösung wurde langsam zu einer auf -78 °C gekühlten Lösung von 10.00 g (45 mmol) Cyanurchlorid in 400 mL abs. Tetrahydrofuran getropft und die Kühlung wurde entfernt. Nach Erreichen der RT wurde das ausgefallene Produkt abfiltriert. Die Ausbeute beträgt 21.08 g (37 mmol), entsprechend 67.9 % der Theorie.

### b) Synthese von 2-(4,6-Bis-[3,1';5,1"]-terphen-1-yl)-1,3,5-triazin-2-yl)-spiro-9,9' -bifluoren

17.46 g (48 mmol) Spiro-9,9'-bifluoren-2-boronsäure, 21.06 g (37 mmol) 2-Chlor-(4,6-Bis-[3,1';5,1"]-terphen-1-yl)-1,3,5-triazin und 21.4 g (101 mmol) Trikaliumphosphat in 1200 mL Toluol, 1200 mL Dioxan und 480 mL Wasser suspendiert. Zu dieser Suspension werden 438 mg (1.4 mmol) Tri-o-tolylphosphin und dann 54 mg (0.3 mmol) Palladium(ll)acetat gegeben, und die Reaktionsmischung wird 16 h unter Rückfluss erhitzt. Nach Erkalten wird die organische Phase abgetrennt, über Kieselgel filtriert, dreimal mit 500 mL Wasser gewaschen und anschließend zur Trockene eingeengt. Der Rückstand wird aus Toluol umkristallisiert und abschließend im Hochvakuum sublimiert. Die Ausbeute beträgt 20.21 g (24 mmol), entsprechend 64.4 % der Theorie.

### Beispiel 2: Synthese von 2-(4,6-Bis-(3-([3,1';5,1"]-terphen-1-yl)-phen-1-yl)-1,3,5-triazin-2-yl)-spiro-9,9'-bifluoren

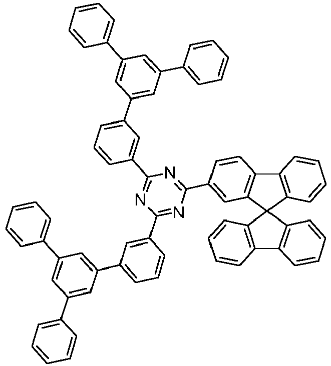

### a) Synthese von 1-Brom-3-([3,1';5,1"]-terphen-1-yl)-phenyl

40.0 g (146 mmol) 3-Boronsäure-[3,1';5,1"]-terphenyl, 18.8 g (146 mmol) 1-lod-3-bromphenyl und 109.3 g (730 mmol) Kaliumcarbonat werden in 1350 mL Toulol und 1150 mL Wasser suspendiert. Zu dieser Suspension werden 844 mg (0.73 mmol) Palladium(0)tetrakis(triphenylphosphin) gegeben, und die Reaktionsmischung wird 16 h unter Rückfluss erhitzt. Nach Erkalten wird die organische Phase abgetrennt, dreimal mit 200 mL Wasser gewaschen, mit Natriumsulfat getrocknet und anschließend zur Trockene eingeengt. Der Rückstand wird mit Ethanol gewaschen und aus Ethylacetat umkristallisiert und abschließend bei vermindertem Druck getrocknet. Die Ausbeute beträgt 47.6 g (123 mmol), entsprechend 84.5 % der Theorie.

### b) Synthese von 2-Chlor-4,6-bis-(3-([3,1';5,1"]-terphen-1-yl)-phen-1-yl)-1,3,5-triazin

Die Synthese wird analog Beispiel 1 durchgeführt, wobei 1-Brom-[3,1';5,1"]-terphen-1-yl durch 43.88 g (143 mmol) 1-Brom-3-([3,1';5,1"]-terphen-1-yl)-phenyl ersetzt wird. Die Ausbeute beträgt 6.30 g (9.0 mmol), entsprechend 23.3 % der Theorie.

### c) Synthese von 2-(4,6-Bis-(3-([3,1';5,1"]-terphen-1-yl)-phen-1-yl)-1,3,5-triazin-2-yl)-spiro-9,9'-bifluoren

Die Synthese wird analog Beispiel 1 mit 4.07 g (11.3 mmol) Spiro-9,9'-bifluoren-2-boronsäure durchgeführt, wobei 2-Chlor-(4,6-bis-[3,1';5,1"]-terphen-1-yl)-1,3,5-triazin durch 6.30 g (9.0 mmol) 2-Chlor-4,6-bis-(3-([3,1';5,1"]-terphen-1-yl)-phen-1-yl)-1,3,5-triazin ersetzt wird. Die Ausbeute beträgt 4.9 g (4.8 mmol), entsprechend 56.3 % der Theorie.

### Beispiel 3: Synthese von 2-(4,6-Diphenyl-1,3,5-triazin-2-yl)-2',7'-bis ([3,1';5,1"]-terphen-1-yl)-spiro-9,9'-bifluoren

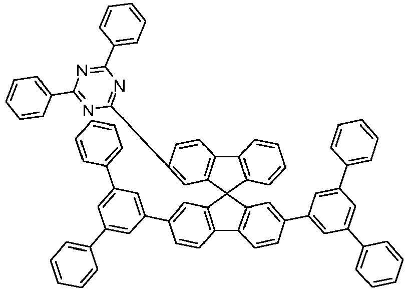

### a) Synthese von 2-(4,6-Diphenyl-1,3,5-triazin-2-yl)-2',7'-dibrom-spiro-9,9'-bifluoren

47.90 g (89 mmol) 2-Chlorocarbonyl-2',7'-dibrom-spiro-9,9'-bifluoren, 11.90 g (89 mmol) Aluminiumtrichlorid und 1.9 mL (27 mmol) Thionylchlorid wurden in einem Kolben mit 260 mL Dichlorbenzol suspendiert. Dann wurden 19.3 mL (187 mmol) Benzonitril langsam hinzugefügt. Die Reaktionmischung wurde 1 h bei 100°C gerührt. 9.55 g (179 mmol) Ammoniumchlorid wurden hinzugefügt und der Ansatz wurde 16 h lang bei 100°C gerührt. Nach Abkühlen auf RT wurde die Reaktionslösung auf 3.5 L Methanol gegeben und 45 min lang gerührt. Der ausgefallene Feststoff wurde abfiltriert und aus Toluol umkristallisiert. Die Ausbeute beträgt 18.8 g (26.7 mmol), entsprechend 29.8 % der Theorie.

### b) Synthese von 2-(4,6-Diphenyl-1,3,5-triazin-2-yl)-2',7'-bis-([3,1';5,1"]-terphen-1-yl)-spiro-9,9'-bifluoren

Die Synthese wird analog Beispiel 1 durchgeführt, wobei Spiro-9,9'-bifluoren-2-boronsäure durch 10.65 g (38.9 mmol) [3,1';5,1"]-Terphen-1-yl boronsäure und 2-Chlor-(4,6-Bis-[3,1';5,1"]-terphen-1-yl)-1,3,5-triazin durch 11.42 g (16.2 mmol) 2-(4,6-Diphenyl-1,3,5-triazin-2-yl)-2',7'-dibromspiro-9,9'-bifluoren ersetzt wird. Die Ausbeute beträgt 14.62 g (14.6 mmol), entsprechend 89.7 % der Theorie.

### Beispiele 4 bis 17: Herstellung der OLEDs

Die Herstellung von erfindungsgemäßen OLEDs sowie OLEDs nach dem Stand der Technik erfolgt nach einem allgemeinen Verfahren gemäß WO 04/058911, das auf die hier beschriebenen Gegebenheiten (Schichtdickenvariation, verwendete Materialien) angepasst wird.

In den folgenden Beispielen 4 bis 17 (siehe Tabelle 2) werden die Ergebnisse verschiedener OLEDs vorgestellt. Glasplättchen, die mit strukturiertem ITO (Indium Zinn Oxid) der Dicke 150 nm beschichtet sind, bilden die Substrate der OLEDs. Zur verbesserten Prozessierung wird 20 nm PEDOT (aus Wasser aufgeschleudert; bezogen von H. C. Starck, Goslar, Deutschland; Poly(3,4-ethylendioxy-2,5-thiophen)) auf das Substrat aufgebracht. Die OLEDs bestehen aus folgender Schichtenfolge: Substrat / PEDOT 20 nm / Lochinjektionsschicht (HIL1) 5 nm / Lochtransportschicht (HTM1) 140 nm / NPB 20 nm / Emissionschicht (EML) 30 nm / Elektronentransportschicht (ETM) 20 nm und abschließend eine Kathode. Die zur Herstellung der OLEDs verwendeten Materialien sind in Tabelle 1 gezeigt.

Alle Materialien bis auf PEDOT werden in einer Vakuumkammer thermisch aufgedampft. Dabei besteht die Emissionsschicht immer aus einem Matrixmaterial (Host) und einem Dotierstoff (Dotand), der dem Host durch Coverdampfung beigemischt wird. In den Beispielen 4 bis 17 wird als Matrixmaterial die Verbindung H1 verwendet, welche jeweils mit 5 % D1 bzw. 1 % D2 dotiert ist. Die OLEDs zeigen blaue Emission. Die Kathode wird durch eine optionale Elektroneninjektionsschicht (LiF oder LiQ) und eine darauf abgeschiedene, 100 nm dicke Al-Schicht gebildet.

Die OLEDs werden standardmäßig charakterisiert; hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Helligkeit, berechnet aus Strom-Spannungs-Helligkeits-Kennlinien (IUL-Kennlinien), sowie die Lebensdauer bestimmt. Als Lebensdauer wird die Zeit definiert, nach der die Anfangshelligkeit von 6000 cd/m² auf die Hälfte gesunken ist. Die gemäß den gezeigten Beispiele 4 bis 12 hergestellten OLEDs haben alle vergleichbare CIE Farbkoordinaten sowie eine vergleichbare Lebensdauer von etwa 150 h bei der angegebenen Starthelligkeit. Dies entspricht ca. 5500 h bei einer Starthelligkeit von 1000 cd/m², wenn man dem Fachmann bekannte Extrapolationsformeln zu Grunde legt. Bei den Beispielen 13 und 14 beträgt die Lebensdauer bei einer Starthelligkeit von 6000 cd/m² etwa 110 h, was einer Lebensdauer von etwa 4000 h bei 1000 cd/m² entspricht. In den Beispielen 15 und 16 beträgt die Lebensdauer bei einer Starthelligkeit von 6000 cd/m² etwa 500 h (Beispiel 15) bzw. 540 h (Beispiel 16), was einer Lebensdauer von etwa 18000 h bzw. 19400 h bei 1000 cd/m² entspricht. In Beispiel 17 beträgt die Lebensdauer bei einer Starthelligkeit von 6000 cd/m² etwa 300 h, was einer Lebensdauer von etwa 11000 h bei 1000 cd/m² entspricht.

In Tabelle 2 sind die Ergebnisse einiger OLEDs (Beispiele 4 bis 17, Lebensdauerwerte im Fließtext angegeben) zusammengefasst. Als erfindungsgemäße Elektronentransportmaterialien werden die Verbindungen ETM3, ETM4 und ETM5 aus Tabelle 1 verwendet, wobei die Verbindungen in der Elektronentransportschicht teilweise als Mischung mit LiQ vorliegen. In Tabelle 2 bedeutet eine Angabe wie ETM4:LiQ (40% : 60%), dass die Verbindung ETM4 in einer Mischung mit LiQ, und zwar in einem Volumenverhältnis von 40% ETM4 und 60% LiQ aufgebracht wird. Eine solche Schicht wird analog der Emissionsschicht durch Coverdampfung der beiden Materialien hergestellt. Als Stand der Technik sind Elektronentransportschichten mit den Verbindungen Alq₃, ETM1 (gemäß WO 08/145239) und ETM2 (gemäß WO 03/060956), teilweise ebenfalls gemischt mit LiQ, angegeben.

Verglichen mit dem Stand der Technik zeichnen sich die erfindungsgemäßen Elektrolumineszenzvorrichtungen mit ETM3, ETM4 und ETM5 vor allem durch eine signifikant erhöhte Leistungseffizienz aus.

Vergleicht man Elektronentransportschichten, die nicht mit LiQ gemischt sind (Beispiele 4, 5, 8, 10 und 17), so zeigt sich bei Verwendung von ETM4 (Beispiel 10) gegenüber dem besten Beispiel gemäß dem Stand der Technik (Verwendung von ETM2, Beispiel 5) eine um 14% erhöhte Leistungseffizienz. Bei Verwendung von ETM5 (Beispiel 17) zeigt sich gegenüber dem besten Beispiel gemäß dem Stand der Technik (Verwendung von ETM2, Beispiel 5) eine um 80% erhöhte Leistungseffizienz. Dies stellt eine signifikante Verbesserung dar.

Bei Verwendung von erfindungsgemäßen Elektronentransportschichten bestehend aus einer Mischung einer triazinhaltigen Verbindung mit LiQ lassen sich noch weit größere Verbesserungen erzielen. Gegenüber dem besten Wert gemäß dem Stand der Technik, Beispiel 7, lässt sich beim Einsatz der erfindungsgemäßen Verbindungen ETM3 und ETM4 in Mischung mit LiQ eine deutlich verbesserte Leistungseffizienz erzielen. Beim Einsatz einer ETM3:LiQ Mischung im Verhältnis 40 % zu 60 % lässt sich eine Verbesserung um 10% erreichen (Vergleich von Beispiel 7 mit Beispiel 12). Eine weitere Verbesserung in der Leistungseffizienz gegenüber dem Stand der Technik auf 23 % ist durch die Verwendung der erfindungsgemäßen Elektronentransportschicht bestehend aus einer Mischung von ETM4 mit LiQ im Verhältnis 40 zu 60% möglich (Vergleich von Beispiel 7 mit Beispiel 11).
Eine weitere Verbesserung in der Leistungseffizienz um 24% gegenüber dem Stand der Technik ist durch die Verwendung der erfindungsgemäßen Elektronentransportschicht bestehend aus einer Mischung von ETM5 mit LiQ im Verhältnis 40 zu 60 % möglich (Vergleich von Beispiel 7 mit Beispiel 15).
Mit ETM5 wurde gezeigt, dass auf Kosten einer leicht verringerten Leistungseffizienz (-12%) mit einer Mischung aus ETM5:LiQ (Beispiel 16) gegenüber ETM5 (Beispiel 17) die Lebensdauer von 300h bei 6000 cd/m² (Beispiel 17) auf 540 h bei 6000 cd/m² (Beispiel 16) gesteigert werden konnte (nicht in Tabelle aufgeführt). Das stellt eine erhebliche Verbesserung um etwa 80 % dar.

Eine sehr große Verbesserung gegenüber dem Stand der Technik zeigen die erfindungsgemäßen Elektronentransportschichten auch beim Einsatz des Dotanden D2 anstelle von D1. Der Dotand D2 unterscheidet sich von D1 im Wesentlichen durch die Abwesenheit von Amingruppen und ein damit wesentlich tieferes HOMO- bzw. LUMO-Niveau. Im Vergleich zu einer Elektronentransportschicht bestehend aus ETM1 gemäß dem Stand der Technik lässt sich bei Verwendung der erfindungsgemäßen ETM4:LiQ (40%:60%) Elektronentransportschicht eine Steigerung der Leistungseffizienz um 70% bei praktisch unveränderten Farbkoordinaten erreichen, was einen außerordentlich hohen Wert darstellt (Vergleich von Beispiel 13 mit Beispiel 14).

**Tabelle 1**

| | |
|---|---|
| 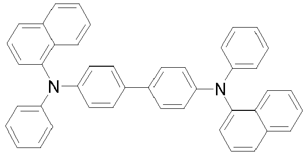 | 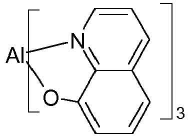 |
| NPB | AlQ₃ |
| 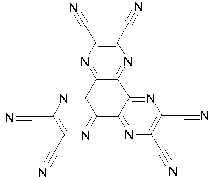 | 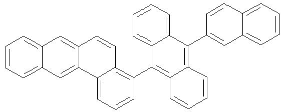 |
| HIL1 | H1 |
| 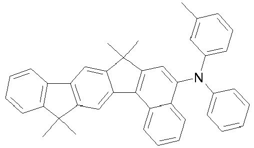 | 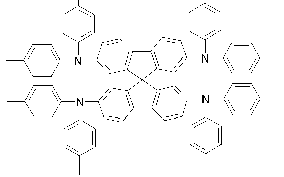 |
| D1 | HTM1 |
| 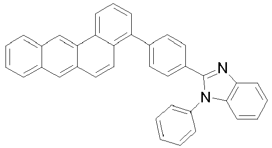 | 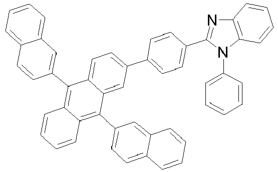 |
| ETM1 | ETM2 |
| 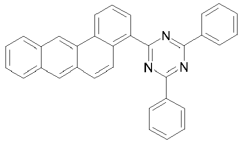 | 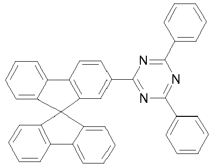 |
| ETM3 | ETM4 |
| 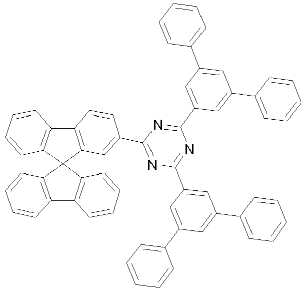 | 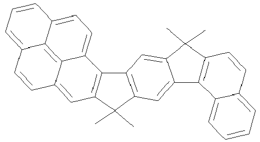 |
| ETM5 | D2 |
| 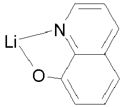 | |
| LiQ | |

**Tabelle 2**

| Bsp. | Dotand | ETM | EIM | Spannung für 1000 cd/m² | Effizienz bei 1000 cd/m² | Effizienz bei 1000 cd/m² | EQE bei 1000 cd/m² | CIE x/y bei 1000 cd/m² |
|---|---|---|---|---|---|---|---|---|
| 4 Vergl. | D1 | Alq₃ | LiF 1nm | 6.4 V | 5.1 cd/A | 2.5 lm/W | 4.2% | 0.142/0.151 |
| 5 Vergl. | D1 | ETM2 | LiQ 1nm | 5.4 V | 6.0 cd/A | 3.5 lm/W | 4.9% | 0.139/0.153 |
| 6 Vergl. | D1 | Alq₃:LiQ (40%:60%) | --- | 6.6 V | 5.7 cd/A | 2.7 lm/W | 4.7% | 0.142/0.151 |
| 7 Vergl. | D1 | ETM2:LiQ (40%:60%) | --- | 4.7 V | 8.1 cd/A | 5.4 lm/W | 6.3% | 0.142/0.155 |
| 8 Vergl. | D1 | ETM2 | LiF 1nm | 6.2 V | 5.9 cd/A | 3.0 lm/W | 4.7% | 0.141/0.160 |
| 9 Vergl. | D1 | ETM1:LiQ (40%:60%) | --- | 6.3 V | 5 cd/A | 2.5 lm/W | 4.0% | 0.142/0.156 |
| 10 | D1 | ETM4 | LiQ 1nm | 5.1 V | 6.5 cd/A | 4.0 lm/W | 5.3% | 0.141/0.157 |
| 11 | D1 | ETM4:LiQ (40%:60%) | --- | 4.4 V | 9.3 cd/A | 6.6 lm/W | 7.5% | 0.142/0.154 |
| 12 | D1 | ETM3:LiQ (40%:60%) | --- | 4.5 V | 8.5 cd/A | 5.9 lm/W | 7.2% | 0.143/0.156 |
| 13 Vergl. | D2 | ETM1 | LiF 1nm | 5.9 V | 4.0 cd/A | 2.1 lm/W | 4.0% | 0.141/0.095 |
| 14 | D2 | ETM4:LiQ (40%:60%) | --- | 4.9 V | 5.7 cd/A | 3.6 lm/W | 6.6% | 0.141/0.091 |
| 15 | D1 | ETM5:LiQ (40%:60%) | LiQ 1nm | 4.3 V | 9.2 cd/A | 6.7 lm/W | 7.2% | 0.142/0.153 |
| 16 | D1 | ETM5:LiQ (40%:60%) | --- | 4.4 V | 8.9 cd/A | 6.4 lm/W | 6.9% | 0.142/0.155 |
| 17 | D1 | ETM5 | LiQ 1nm | 4.1 V | 9.3 cd/A | 7.1 lm/W | 7.1% | 0.141/0.159 |

### Beispiel 18: Vergleich der Prozessierbarkeit

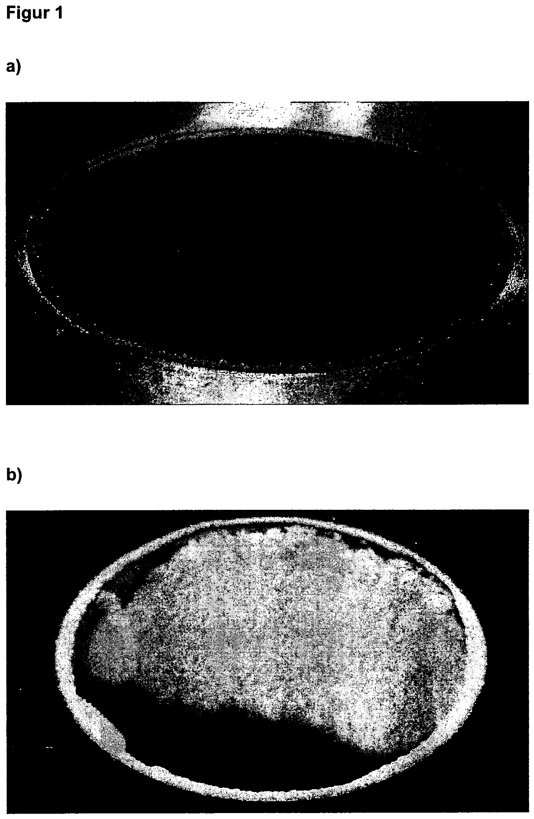

Ein weiterer Vorteil der erfindungsgemäßen Elektronentransportmaterialien ist die wesentlich verbesserte Prozessierbarkeit gegenüber dem Stand der Technik ETM2. Von den Materialien ETM 4 und ETM2 werden bei gleichen Aufdampfbedingungen (Aufdampfrate von 0.1 nm/s) über 2 Stunden Schichten abgeschieden. Unter diesen Bedingungen zeigt ETM4 keinerlei Neigung zur Verstopfung der Aufdampfquelle ("clogging"). Im Gegensatz dazu wächst am oberen Rand der Aufdampfquelle bei Verwendung der Verbindung ETM2 eine Schicht des Materials ringförmig nach innen, so dass bereits nach etwa 1.5 h keine kontrollierte Schichtabscheidung mit der Verbindung ETM2 mehr möglich ist. Dies wird durch Fotos in Figur 1 belegt, wobei Figur 1 a) die Aufdampfquelle unter Verwendung von ETM4 zeigt und Figur 1 b) die Aufdampfquelle unter Verwendung von ETM2, jeweils nach 1.5 h Aufdampfung mit einer Aufdampfgeschwindigkeit von jeweils ca. 1 nm/s. In Figur 1 a) ist keinerlei Verstopfung der Aufdampfquelle zu erkennen, während in Figur 1 b) bereits nach 1.5 h die Quelle so weit zugewachsen ist (in der Figur zu erkennen durch den hellen "Deckel"), dass hier keine kontrollierte weitere Abscheidung möglich ist. Damit ist die erfindungsgemäße Verbindung ETM4 wesentlich besser für einen Einsatz in der Massenproduktion geeignet als die Verbindung ETM2 gemäß dem Stand der Technik.

## Patentansprüche

1. Organische Elektrolumineszenzvorrichtung enthaltend Anode, Kathode und
entweder
mindestens eine emittierende Schicht, welche mindestens einen fluoreszierenden Emitter enthält und wobei zwischen der emittierenden Schicht und der Kathode eine Elektronentransportschicht eingebracht ist oder
mindestens eine emittierende Schicht, welche mindestens einen phosphoreszierenden Emitter enthält und welche in Kombination mit einer folgenden Lochblockierschicht eingesetzt wird und wobei zwischen der Lochblockierschicht und der Kathode eine Elektronentransportschicht eingebracht ist,
**dadurch gekennzeichnet, dass** die Elektronentransportschicht mindestens eine Verbindung gemäß Formel (1) oder Formel (2) enthält, 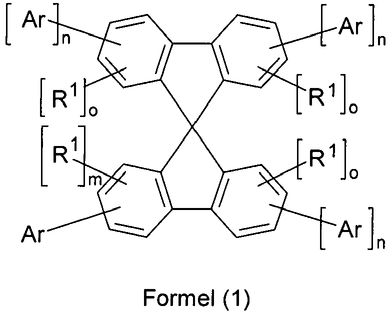 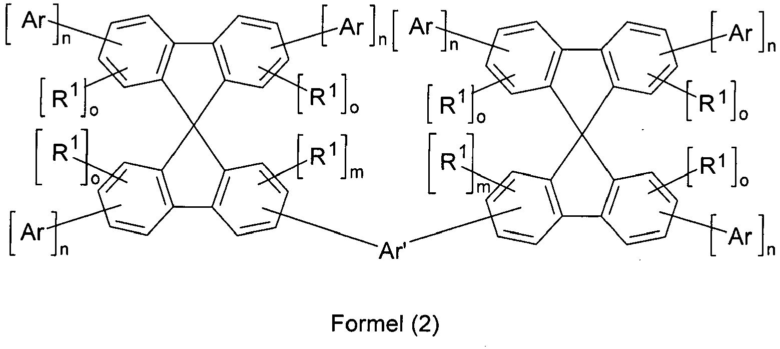 wobei für die verwendeten Symbole und Indizes gilt:
Ar ist eine Gruppe der folgenden Formel (3), 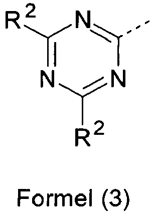 wobei die gestrichelte Bindung die Bindung an das Spirobifluoren andeutet;
Ar' ist eine Gruppe der folgenden Formel (4), 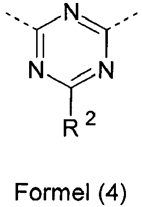 wobei die gestrichelten Bindungen die Bindungen an das Spirobifluoren andeutet;
R¹, R² ist bei jedem Auftreten gleich oder verschieden H, D, F, Cl, Br, I, CHO, N(R³)₂, N(Ar¹)₂, B(Ar¹)₂, C(=O)Ar¹, P(=O)(Ar¹)₂, S(=O)Ar¹, S(=O)₂Ar¹, CR³=CR³Ar¹, CN, NO₂, Si(R³)₃, B(OR³)₂, B(R³)₂, B(N(R³)₂)₂, OSO₂R³, eine geradkettige Alkyl-, Alkenyl-, Alkinyl-, Alkoxy- oder Thioalkoxygruppe mit 1 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C , Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Kombination dieser Systeme; dabei können zwei oder mehrere benachbarte Substituenten R¹ auch miteinander ein mono- oder polycyclisches, aliphatisches oder aromatisches Ringsystem bilden;
Ar¹ ist bei jedem Auftreten gleich oder verschieden ein aromatisches oder heteroaromatisches Ringsystem mit 5 bis 30 aromatischen Ringatomen, das mit einem oder mehreren Resten R³ substituiert sein kann; dabei können auch zwei Reste Ar¹, welche an dasselbe Stickstoff-, Phosphor- oder Boratom binden, durch eine Einfachbindung oder eine Brücke, ausgewählt aus B(R³), C(R³)₂, Si(R³)₂, C=O, C=NR³, C=C(R³)₂, O, S, S=O, SO₂, N(R³), P(R³) und P(=O)R³, miteinander verknüpft sein;
R³ ist bei jedem Auftreten gleich oder verschieden H, D oder ein aliphatischer, aromatischer und/oder heteroaromatischer Kohlenwasserstoffrest mit 1 bis 20 C-Atomen, in dem auch H-Atome durch D oder F ersetzt sein können; dabei können zwei oder mehrere benachbarte Substituenten R³ auch miteinander ein mono- oder polycyclisches, aliphatisches oder aromatisches Ring-system bilden;
n ist 0 oder 1;
m ist 0, 1, 2 oder 3;
o ist 0, 1, 2, 3 oder 4, wenn im selben Ring n = 0 ist und ist 0, 1, 2 oder 3, wenn im selben Ring n = 1 ist.

2. Organische Elektrolumineszenzvorrichtung nach Anspruch 1, **dadurch gekennzeichnet, dass** der Rest R² gleich oder verschieden bei jedem Auftreten für H, D, eine geradkettige Alkyl- oder Alkoxygruppe mit 1 bis 10 C-Atomen oder eine verzweigte oder cyclische Alkyl- oder Alkoxygruppe mit 3 bis 10 C-Atomen, die jeweils mit einem oder mehreren Resten R³ substituiert sein kann, wobei ein oder mehrere H-Atome durch D oder F ersetzt sein können, oder ein aromatisches oder heteroaromatisches Ringsystem mit 5 bis 30 aromatischen Ringatomen, das jeweils durch einen oder mehrere Reste R³ substituiert sein kann, oder eine Kombination dieser Systeme steht; besonders bevorzugt für ein aromatisches oder heteroaromatisches Ringsystem mit 5 bis 25 aromatischen Ringatomen, das jeweils durch einen oder mehrere Reste R³ substituiert sein kann; insbesondere für Phenyl, Naphthyl oder ortho-, meta- bzw. para-Biphenyl, welches jeweils durch einen oder mehrere Reste R³ substituiert sein kann, jedoch bevorzugt unsubstituiert ist.

3. Organische Elektrolumineszenzvorrichtung nach Anspruch 1 oder 2, **dadurch gekennzeichnet, dass** die Verbindung gemäß Formel (1) oder (2) ausgewählt ist aus den Verbindungen gemäß den Formeln (5) und (6), 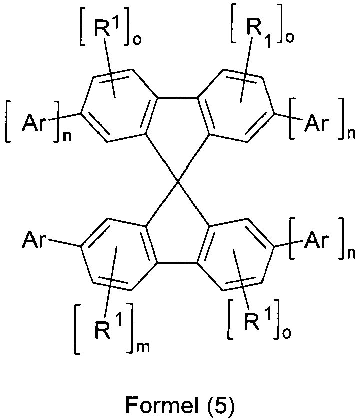 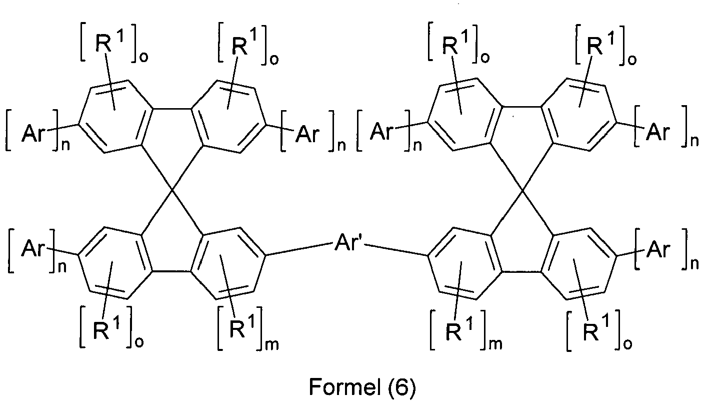 wobei die Symbole und Indizes dieselbe Bedeutung haben, wie in Anspruch 1 beschrieben und wobei für n = 0 in der entsprechenden Position auch ein Substituent R¹ gebunden sein kann.

4. Organische Elektrolumineszenzvorrichtung nach einem oder mehreren der Ansprüche 1 bis 3, **dadurch gekennzeichnet, dass** der Index m = 0 ist und dass an jedem Benzolring die Summe der Indizes n + o = 0 oder 1 ist.

5. Organische Elektrolumineszenzvorrichtung nach einem oder mehreren der Ansprüche 1 bis 4, **dadurch gekennzeichnet, dass** die Verbindung gemäß Formel (1) bzw. Formel (2) ausgewählt ist aus Verbindungen gemäß Formel (7), (8), (9) und (10), 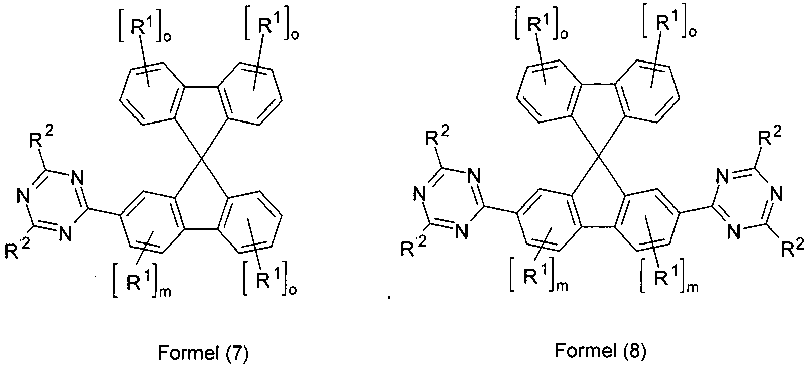 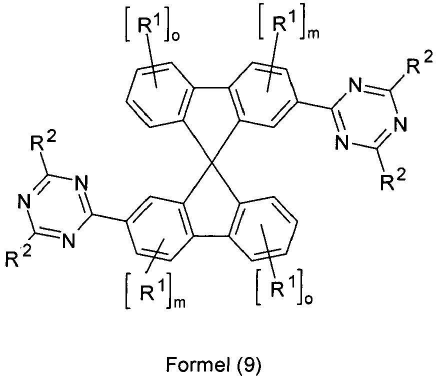 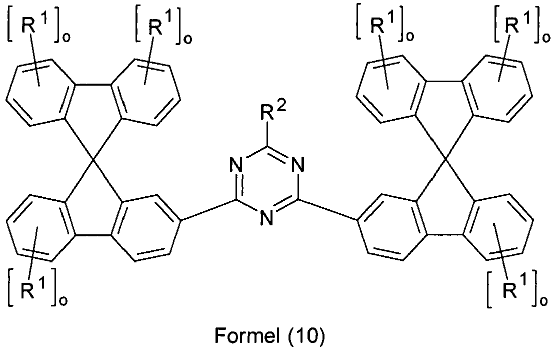 wobei die verwendeten Symbole die in Anspruch 1 genannten Bedeutungen haben und o gleich oder verschieden bei jedem Auftreten für 0 oder 1, bevorzugt für 0, steht.

6. Verfahren zur Herstellung einer organischen Elektrolumineszenzvorrichtung nach einem oder mehreren der Ansprüche 1 bis 5, **dadurch gekennzeichnet, dass** eine oder mehrere Schichten mit einem Sublimationsverfahren beschichtet werden und/oder dass eine oder mehrere Schichten mit dem OVPD (Organic Vapour Phase Deposition) Verfahren oder mit Hilfe einer Trägergassublimation beschichtet werden und/oder dass eine oder mehrere Schichten aus Lösung, bzw. mit einem Druckverfahren beschichtet werden.

## Claims

1. Organic electroluminescent device comprising anode, cathode and either
at least one emitting layer which comprises at least one fluorescent emitter and where an electron-transport layer has been introduced between the emitting layer and the cathode
or
at least one emitting layer which comprises at least one phosphorescent emitter and which is employed in combination with a following hole-blocking layer and where an electron-transport layer has been introduced between the hole-blocking layer and the cathode, **characterised in that** the electron-transport layer comprises at least one compound of the formula (1) or formula (2), 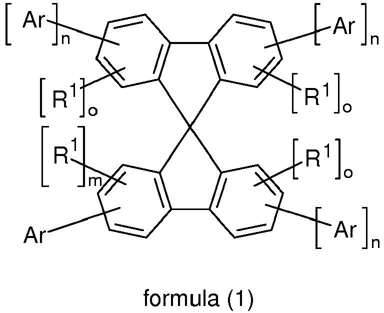 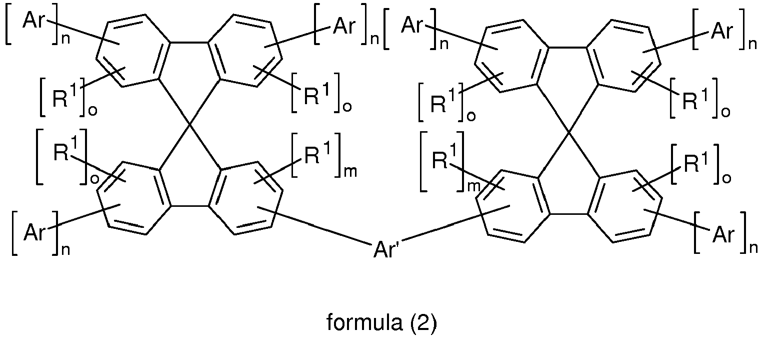 where the following applies to the symbols and indices used:
Ar is a group of the following formula (3), 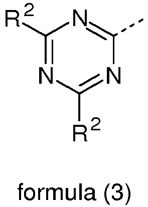 where the dashed bond indicates the bond to the spirobifluorene;
Ar' is a group of the following formula (4), 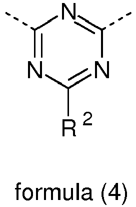 where the dashed bonds indicate the bonds to the spirobifluorene;
R¹, R² are on each occurrence, identically or differently, H, D, F, Cl, Br, I, CHO, N(R³)₂, N(Ar¹)₂, B(Ar¹)₂, C(=O)Ar¹, P(=O)(Ar¹)₂, S(=O)Ar¹, S(=O)₂Ar¹, CR³=CR³Ar¹, CN, NO₂, Si(R³)₃, B(OR³)₂, B(R³)₂, B(N(R³)₂)₂, OSO₂R³, a straight-chain alkyl, alkenyl, alkynyl, alkoxy or thioalkoxy group having 1 to 40 C atoms or a branched or cyclic alkyl, alkenyl, alkynyl, alkoxy or thioalkoxy group having 3 to 40 C atoms, which may in each case be substituted by one or more radicals R³, where one or more non-adjacent CH₂ groups may be replaced by R³C=CR³, C≡C, Si(R³)₂, Ge(R³)₂, Sn(R³)₂, C=O, C=S, C=Se, C=NR³, P(=O)(R³), SO, SO₂, NR³, O, S or CONR³ and where one or more H atoms may be replaced by D, F, Cl, Br, I, CN or NO₂, or an aromatic or heteroaromatic ring system having 5 to 60 aromatic ring atoms, which may in each case be substituted by one or more radicals R³, or an aryloxy or heteroaryloxy group having 5 to 60 aromatic ring atoms, which may be substituted by one or more radicals R³, or a combination of these systems; two or more adjacent substituents R¹ may also form a mono- or polycyclic, aliphatic or aromatic ring system with one another;
Ar¹ is on each occurrence, identically or differently, an aromatic or heteroaromatic ring system having 5 to 30 aromatic ring atoms, which may be substituted by one or more radicals R³; two radicals Ar¹ which are bonded to the same nitrogen, phosphorus or boron atom may also be linked to one another by a single bond or a bridge selected from B(R³), C(R³)₂, Si(R³)₂, C=O, C=NR³, C=C(R³)₂, O, S, S=O, SO₂, N(R³), P(R³) and P(=O)R³;
R³ is on each occurrence, identically or differently, H, D or an aliphatic, aromatic and/or heteroaromatic hydrocarbon radical having 1 to 20 C atoms, in which, in addition, H atoms may be replaced by D or F; two or more adjacent substituents R³ may also form a mono- or polycyclic, aliphatic or aromatic ring system with one another;
n is 0 or 1;
m is 0, 1, 2 or 3;
o is 0, 1, 2, 3 or 4 if n = 0 in the same ring and is 0, 1, 2 or 3 if n = 1 in the same ring.

2. Organic electroluminescent device according to Claim 1, **characterised in that** the radical R² stands, identically or differently on each occurrence, for H, D, a straight-chain alkyl or alkoxy group having 1 to 10 C atoms or a branched or cyclic alkyl or alkoxy group having 3 to 10 C atoms, which may in each case be substituted by one or more radicals R³, where one or more H atoms may be replaced by D or F, or an aromatic or heteroaromatic ring system having 5 to 30 aromatic ring atoms, which may in each case be substituted by one or more radicals R³, or a combination of these systems; particularly preferably for an aromatic or heteroaromatic ring system having 5 to 25 aromatic ring atoms, which may in each case be substituted by one or more radicals R³; in particular for phenyl, naphthyl or ortho-, meta- or para-biphenyl, which may in each case be substituted by one or more radicals R³, but is preferably unsubstituted.

3. Organic electroluminescent device according to Claim 1 or 2, **characterised in that** the compound of the formula (1) or (2) is selected from the compounds of the formulae (5) and (6), 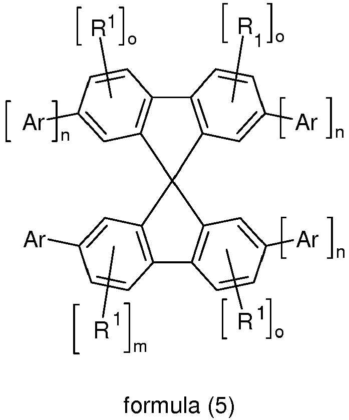 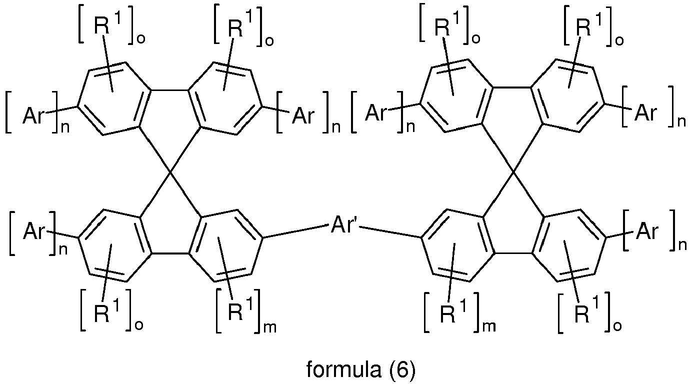 where the symbols and indices have the same meaning as described in Claim 1 and where, for n = 0, a substituent R¹ may also be bonded in the corresponding position.

4. Organic electroluminescent device according to one or more of Claims 1 to 3, **characterised in that** the index m = 0 and **in that** the sum of the indices n + o = 0 or 1 on each benzene ring.

5. Organic electroluminescent device according to one or more of Claims 1 to 4, **characterised in that** the compound of the formula (1) or formula (2) is selected from compounds of the formulae (7), (8), (9) and (10), 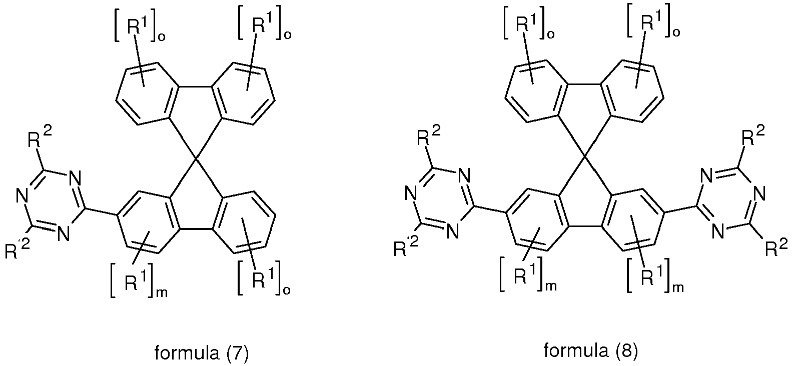 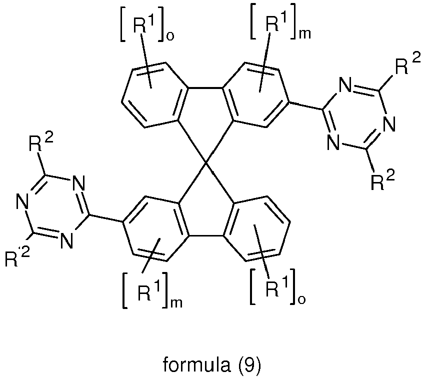 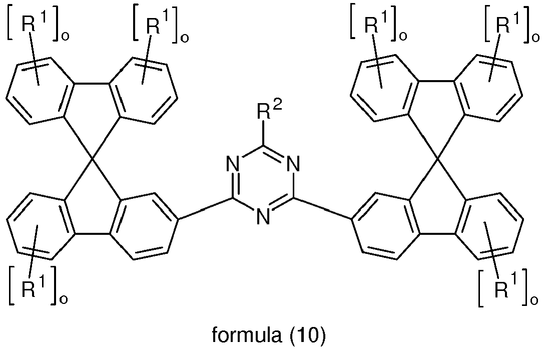 where the symbols used have the meanings given in Claim 1 and o stands, identically or differently on each occurrence, for 0 or 1, preferably for 0.

6. Process for the production of an organic electroluminescent device according to one or more of Claims 1 to 5, **characterised in that** one or more layers are applied by means of a sublimation process and/or **in that** one or more layers are applied by means of the OVPD (organic vapour phase deposition) process or with the aid of carrier-gas sublimation and/or **in that** one or more layers are applied from solution or by means of a printing process.

## Revendications

1. Dispositif électroluminescent organique comprenant une anode, une cathode et
soit au moins une couche d'émission qui comprend au moins un émetteur fluorescent et où une couche de transport d'électrons a été introduite entre la couche d'émission et la cathode
soit au moins une couche d'émission qui comprend au moins un émetteur phosphorescent et qui est utilisée en combinaison avec une couche de blocage de trous qui suit et où une couche de transport d'électrons a été introduite entre la couche de blocage de trous et la cathode,
**caractérisé en ce que** la couche de transport d'électrons comprend au moins un composé de la formule (1) ou de la formule (2) : 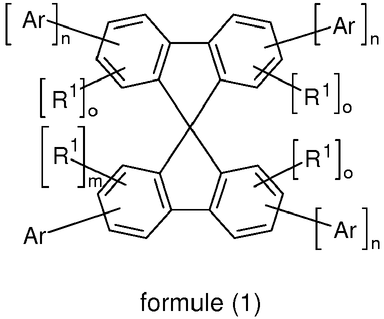 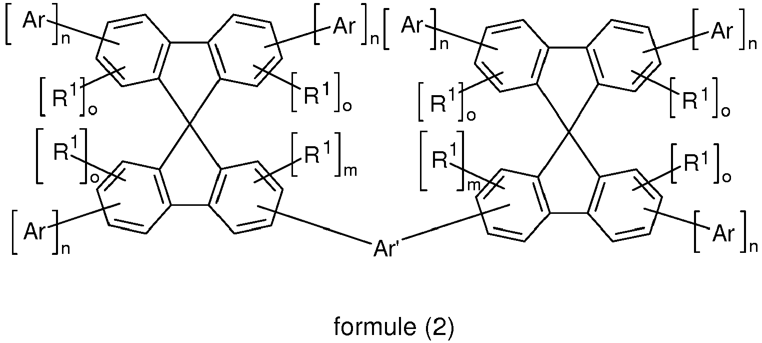 dans lesquelles ce qui suit s'applique aux symboles et aux indices qui sont utilisés :
Ar est un groupe de la formule (3) qui suit : 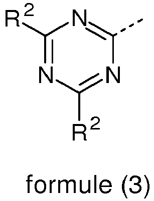 dans laquelle la liaison en pointillés indique la liaison sur le spirobifluorène ;
Ar' est un groupe de la formule (4) qui suit : 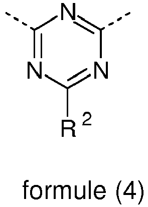 dans laquelle les liaisons en pointillés indiquent les liaisons sur le spirobifluorène ;
R¹, R² sont pour chaque occurrence, de manière identique ou différente, H, D, F, Cl, Br, I, CHO, N(R³)₂, N(Ar¹)₂, B(Ar¹)₂, C(=O)Ar¹, P(=O)(Ar¹)₂, S(=O)Ar¹, S(=O)₂Ar¹, CR³=CR³Ar¹, CN, NO₂, Si(R³)₃, B(OR³)₂, B(R³)₂, B(N(R³)₂)₂, OSO₂R³, un groupe alkyle, alkényle, alkynyle, alcoxy ou thioalcoxy en chaîne droite qui comporte de 1 à 40 atome(s) de C ou un groupe alkyle, alkényle, alkynyle, alcoxy ou thioalcoxy ramifié ou cyclique qui comporte de 3 à 40 atomes de C, lequel peut dans chaque cas être substitué par un radical ou par plusieurs radicaux R³, où un ou plusieurs groupe(s) CH2 non adjacents peut/peuvent être remplacé(s) par R³C=CR³, C=C, Si(R³)₂, Ge(R³)₂, Sn(R³)₂, C=O, C=S, C=Se, C=NR³, P(=O)(R³), SO, SO₂, NR³, O, S ou CONR³ et où un ou plusieurs atome(s) de H peut/peuvent être remplacé(s) par D, F, Cl, Br, I, CN ou NO₂, ou un système de cycle aromatique ou hétéroaromatique qui comporte de 5 à 60 atomes de cycle aromatique, lequel peut dans chaque cas être substitué par un radical ou par plusieurs radicaux R³, ou un groupe aryloxy ou hétéroaryloxy qui comporte de 5 à 60 atomes de cycle aromatique, lequel peut être substitué par un radical ou par plusieurs radicaux R³, ou une combinaison de ces systèmes ; deux substituants R¹ adjacents ou plus peuvent également former un système de cycle aliphatique ou aromatique monoou polycyclique l'un avec l'autre ou les uns avec les autres ;
Ar¹ est pour chaque occurrence, de manière identique ou différente, un système de cycle aromatique ou hétéroaromatique qui comporte de 5 à 30 atomes de cycle aromatique, lequel peut être substitué par un radical ou par plusieurs radicaux R³ ; deux radicaux Ar¹ qui sont liés au même atome d'azote, de phosphore ou de bore peuvent également être liés l'un à l'autre au moyen d'une liaison simple ou d'un pont qui est sélectionné parmi B(R³), C(R³)₂, Si(R³)₂, C=O, C=NR³, C=C(R³)₂, O, S, S=O, SO₂, N(R³), P(R³) et P(=O)R³ ;
R³ est pour chaque occurrence, de manière identique ou différente, H, D ou un radical hydrocarbone aliphatique, aromatique et/ou hétéroaromatique qui comporte de 1 à 20 atome(s) de C, où, en outre, des atomes de H peuvent être remplacés par D ou par F ; deux substituants R³ adjacents ou plus peuvent également former un système de cycle aliphatique ou aromatique mono- ou polycyclique l'un avec l'autre ou les uns avec les autres ;
n est 0 ou 1 ;
m est 0, 1, 2 ou 3 ;
o est 0, 1, 2, 3 ou 4 si n = 0 dans le même cycle et est 0, 1, 2 ou 3 si n = 1 dans le même cycle.

2. Dispositif électroluminescent organique selon la revendication 1, **caractérisé en ce que** le radical R² représente, de manière identique ou différente pour chaque occurrence, H, D, un groupe alkyle ou alcoxy en chaîne droite qui comporte de 1 à 10 atome(s) de C ou un groupe alkyle ou alcoxy ramifié ou cyclique qui comporte de 3 à 10 atomes de C, lequel peut dans chaque cas être substitué par un radical ou par plusieurs radicaux R³, où un ou plusieurs atome(s) de H peut/peuvent être remplacé(s) par D ou par F, ou un système de cycle aromatique ou hétéroaromatique qui comporte de 5 à 30 atomes de cycle aromatique, lequel peut dans chaque cas être substitué par un radical ou par plusieurs radicaux R³, ou une combinaison de ces systèmes ; de façon particulièrement préférable, un système de cycle aromatique ou hétéroaromatique qui comporte de 5 à 25 atomes de cycle aromatique, lequel peut dans chaque cas être substitué par un radical ou par plusieurs radicaux R³; en particulier phényle, naphtyle ou ortho-, méta- ou para-biphényle, lequel peut dans chaque cas être substitué par un radical ou par plusieurs radicaux R³, mais est de préférence non substitué.

3. Dispositif électroluminescent organique selon la revendication 1 ou 2, **caractérisé en ce que** le composé de la formule (1) ou (2) est sélectionné parmi les composés des formules (5) et (6) : 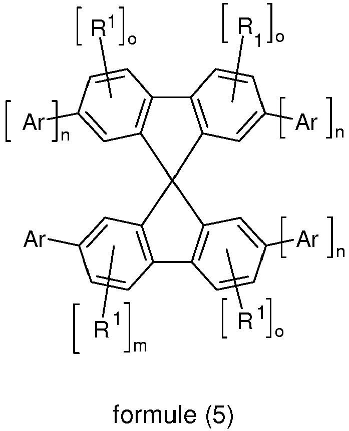 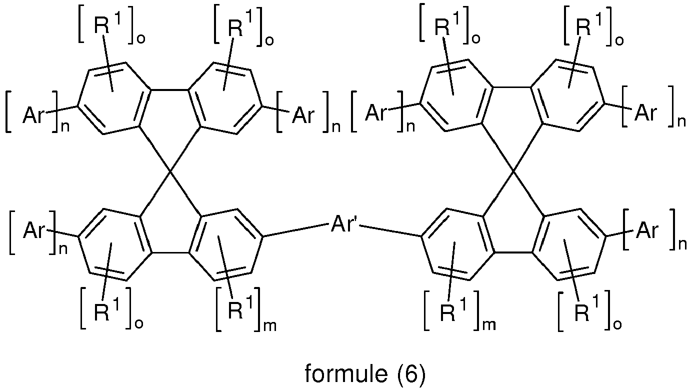 dans lesquelles les symboles et les indices présentent la même signification que celle qui a été décrite selon la revendication 1 et où, pour n = 0, un substituant R¹ peuvent également être lié au niveau de la position correspondante.

4. Dispositif électroluminescent organique selon une ou plusieurs des revendications 1 à 3, **caractérisé en ce que** l'indice m = 0 et **en ce que** la somme des indices n + o = 0 ou 1 sur chaque cycle benzène.

5. Dispositif électroluminescent organique selon une ou plusieurs des revendications 1 à 4, **caractérisé en ce que** le composé de la formule (1) ou de la formule (2) est sélectionné parmi les composés des formules (7), (8), (9) et (10) : 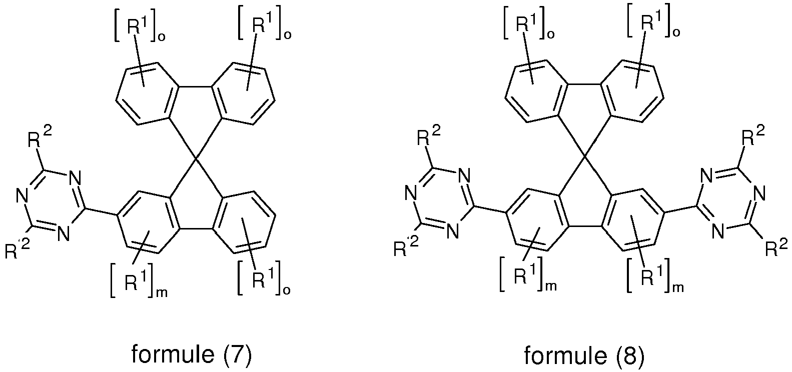 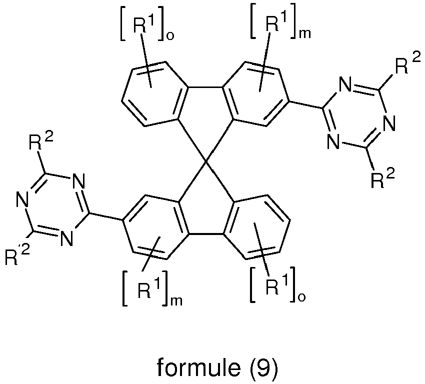 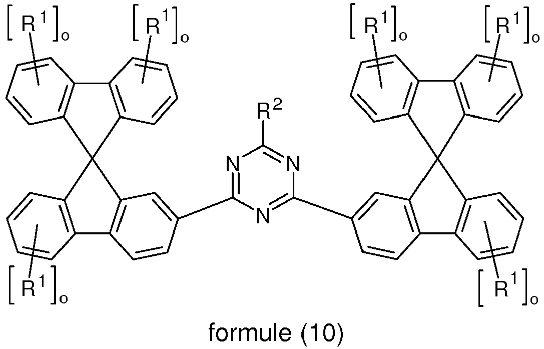 dans lesquelles les symboles qui sont utilisés présentent les significations qui ont été données selon la revendication 1 et o représente, de manière identique ou différente pour chaque occurrence, 0 ou 1, de préférence 0.

6. Procédé pour la fabrication d'un dispositif électroluminescent organique selon une ou plusieurs des revendications 1 à 5, **caractérisé en ce qu'**une ou plusieurs couche(s) est/sont appliquée(s) au moyen d'un processus de sublimation et/ou **en ce qu'**une ou plusieurs couche(s) est/sont appliquée(s) au moyen du processus OVPD (dépôt en phase vapeur organique) ou à l'aide d'une sublimation par gaz porteur et/ou **en ce qu'**une ou plusieurs couche(s) est/sont appliquée(s) à partir d'une solution ou au moyen d'un processus d'impression.
